# EUROPEAN PATENT APPLICATION

(11) **EP 4 668 256 A1**
(43) Date of publication of application: **24.12.2025**
(21) Application number: 25183670.6
(22) Date of filing: 18.06.2025
(51) Int. Cl.: G09G 3/3266

(54) **SCAN DRIVER AND DISPLAY DEVICE INCLUDING THE SAME, AND ELECTRONIC DEVICE**

(30) Priority: 19.06.2024 KR 20240079895; 09.09.2024 KR 20240122284
(71) Applicant: Samsung Display Co., Ltd., Yongin-si, Gyeonggi-do 17113 (KR)
(72) Inventor: JEONG, Il Hun, 17113 Yongin-si, Gyeonggi-do, (KR); KIM, Hye Sung, 17113 Yongin-si, Gyeonggi-do, (KR)
(74) Representative: Gulde & Partner

(57) **Abstract**

A stage circuit controls the voltage of an output terminal based on the voltages of a first and second node. The circuit includes: a first transistor between a first input terminal and a third node, with its gate connected to a second input terminal; a second transistor between a first power input terminal and the output terminal, with its gate connected to the first node; a third transistor between a third input terminal and the output terminal, with its gate connected to the second node; a fourth transistor between the first node and the second input terminal, with its gate connected to the third node; and a fifth transistor between the first node and a second power input terminal, with its gate connected to the second input terminal. During part of the period when the first transistor is on, the third node connects to the second node.

## Description

### 1. Technical Field

Embodiments of the present disclosure relate to a scan driver and a display device including the same, and electronic device.

### 2. Discussion of Related Art

A display device is a connection medium between users and information. Examples of the display devices include liquid crystal display devices and organic light emitting display devices.

The display device includes pixels for displaying an image. The pixels may receive a data signal corresponding to a scan signal supplied from a scan driver and emit light with a brightness corresponding to the data signal. The scan driver may include a plurality of stage circuits to supply the scan signal. However, traditional stage circuit can be inefficient in their use of power and may require more space due to their complex circuit designs.

### SUMMARY

One object of the present disclosure is to provide a stage circuit for a scan driver and a display device including the same capable of minimizing or reducing power consumption and mounting area.

According to an embodiment, a scan driver for a display device includes a stage circuit. The stage circuit controls a voltage of an output terminal based on voltages of a first node and a second node. The stage circuit includes: a first transistor connected between a first input terminal and a third node, a gate electrode of the first transistor being connected to a second input terminal; a second transistor connected between a first power input terminal and the output terminal, a gate electrode of the second transistor being connected to the first node; a third transistor connected between a third input terminal and the output terminal, a gate electrode of the third transistor being connected to the second node; a fourth transistor connected between the first node and the second input terminal, a gate electrode of the fourth transistor being connected to the third node; and a fifth transistor connected between the first node and a second power input terminal, a gate electrode of the fifth transistor being connected to the second input terminal. The third node is electrically connected to the second node during at least a portion of a period in which the first transistor is turned on.

According to an embodiment, the stage circuit further includes a first capacitor connected between the output terminal and the second node, and a second capacitor connected between the first power input terminal and the first node.

According to an embodiment, the first input terminal receives a start signal or a carry signal from a previous stage circuit, the second input terminal receives a first clock signal, the third input terminal receives a second clock signal having the same period but different phase than the first clock signal, the first power input terminal receives a voltage of a first power source and the second power input terminal receives a voltage of a second power source having a lower voltage than that of the first power.

According to an embodiment, the stage circuit further includes a sixth transistor connected between the second node and the third node, a gate electrode of the sixth transistor being connected to the second power input terminal.

According to an embodiment, the stage circuit further includes a sixth transistor connected between the second node and the third node, a gate electrode of the sixth transistor being connected to the second input terminal.

According to an embodiment, the stage circuit further includes a sixth transistor connected between the second node and the third node, a gate electrode of the sixth transistor being connected to the first node.

According to an embodiment, the stage circuit further includes an auxiliary transistor connected in parallel to the first transistor across the first input terminal and the third node, a gate electrode of the auxiliary transistor being connected to the first node.

According to an embodiment, the stage circuit further includes a sixth transistor connected between the second node and the third node, a gate electrode of the sixth transistor being connected to the second power input terminal.

According to an embodiment, the stage circuit further includes a sixth transistor connected between the second node and the third node, a gate electrode of the sixth transistor being connected to the second input terminal.

According to an embodiment, the stage circuit further includes a sixth transistor connected between the second node and the third node, a gate electrode of the sixth transistor being connected to the first node.

According to an embodiment, the stage circuit further includes a seventh transistor connected between the first power input terminal and the third node, a gate electrode of the seventh transistor is connected to the first node.

According to an embodiment, the stage circuit further includes a sixth transistor connected between the second node and the third node, a gate electrode of the sixth transistor being connected to the second power input terminal.

According to an embodiment, a scan driver for a display device includes a stage circuit. The stage circuit controls a voltage of an output terminal based on voltages of a first node and a second node. The stage circuit includes: a first transistor connected between a first input terminal and a third node, a gate electrode of the first transistor being connected to a second input terminal; a second transistor connected between a first power input terminal and the output terminal, a gate electrode of the second transistor being connected to the first node; a third transistor connected between a third input terminal and the output terminal, a gate electrode of the third transistor being connected to the second node; a fourth transistor having a first electrode connected to the second input terminal and a second electrode and a gate electrode connected to the first node; and a fifth transistor connected between the first node and a second power input terminal, a gate electrode of the fifth transistor being connected to the second input terminal. The third node is electrically connected to the second node during at least a portion of a period in which the first transistor is turned on.

According to an embodiment, the stage circuit further includes a first capacitor connected between the output terminal and the second node, and a second capacitor connected between the first power input terminal and the first node.

According to an embodiment, the first input terminal receives a start signal or a carry signal from a previous stage circuit, the second input terminal receives a first clock signal, the third input terminal receives a second clock signal having a same period but a different phase from the first clock signal, the first power input terminal receives a voltage of a first power source and the second power input terminal receives a voltage of a second power source having a lower voltage than that of the first power source.

According to an embodiment, the stage circuit further includes a sixth transistor connected between the second node and the third node, a gate electrode of the sixth transistor being connected to the second power input terminal.

According to an embodiment, the stage circuit further includes a sixth transistor connected between the second node and the third node, a gate electrode of the sixth transistor being connected to the second input terminal.

According to an embodiment, the stage circuit further includes a sixth transistor connected between the second node and the third node, a gate electrode of the sixth transistor being connected to the first node.

According to an embodiment, the stage circuit further includes an auxiliary transistor connected in parallel to the first transistor across the first input terminal and the third node, a gate electrode of the auxiliary transistor being connected to the first node.

According to an embodiment, the stage circuit further includes a sixth transistor connected between the second node and the third node, a gate electrode of the sixth transistor being connected to the second power input terminal.

According to an embodiment, the stage circuit further includes a sixth transistor connected between the second node and the third node, a gate electrode of the sixth transistor being connected to the second input terminal.

According to an embodiment, the stage circuit further includes a sixth transistor connected between the second node and the third node, a gate electrode of the sixth transistor being connected to the first node.

According to an embodiment, the stage circuit further includes an auxiliary transistor connected in parallel to the first transistor between the first input terminal and the third node, a gate electrode of the auxiliary transistor being connected to the third input terminal, and a sixth transistor connected between the second node and the third node, a gate electrode of the sixth transistor being connected to the second input terminal.

According to an embodiment, a scan driver for a display device includes a stage circuit which controls a voltage of an output terminal based on voltages of a first node and a second node. The stage circuit includes: a first transistor connected between a first input terminal and a third node, a gate electrode of the first transistor being connected to a second input terminal; a second transistor connected between a first power input terminal and the output terminal, a gate electrode of the second transistor being connected to the first node; a third transistor connected between a third input terminal and the output terminal, a gate electrode of the third transistor being connected to the second node; a fourth transistor connected between the first node and the second input terminal, a gate electrode of the fourth transistor being connected to the third node; and a fifth transistor having a first electrode connected to the first node and a second electrode and a gate electrode connected to the second input terminal. The third node is electrically connected to the second node during at least a portion of a period in which the first transistor is turned on.

According to an embodiment, the stage circuit further includes: a first capacitor connected between the output terminal and the second node, and a second capacitor connected between the first power input terminal and the first node.

According to an embodiment, the first input terminal receives a start signal or a carry signal from a previous stage circuit, the second input terminal receives a first clock signal, the third input terminal receives a second clock signal having a same period but a different phase from the first clock signal, the first power input terminal receives a voltage of a first power source and the second power input terminal receives a voltage of a second power source having a lower voltage than that of the first power source.

According to an embodiment, the stage circuit further includes a sixth transistor connected between the second node and the third node, a gate electrode of the sixth transistor being connected to the second power input terminal.

According to an embodiment, the stage circuit further includes a sixth transistor connected between the second node and the third node, a gate electrode of the sixth transistor being connected to the second input terminal.

According to an embodiment, the stage circuit further includes a sixth transistor connected between the second node and the third node, a gate electrode of the sixth transistor being connected to the first node.

According to an embodiment, the stage circuit further includes an auxiliary transistor connected in parallel to the first transistor across the first input terminal and the third node, a gate electrode of the auxiliary transistor being connected to the first node.

According to an embodiment, the stage circuit further includes a sixth transistor connected between the second node and the third node, a gate electrode of the sixth transistor being connected to the second power input terminal.

According to an embodiment, the stage circuit further includes a sixth transistor connected between the second node and the third node, a gate electrode of the sixth transistor being connected to the second input terminal.

According to an embodiment, the stage circuit further includes a sixth transistor connected between the second node and the third node, a gate electrode of the sixth transistor being connected to the first node.

According to an embodiment, the stage circuit further includes an auxiliary transistor connected in parallel to the first transistor across the first input terminal and the third node, a gate electrode of the auxiliary transistor being connected to the third input terminal, and a sixth transistor connected between the second node and the third node, a gate electrode of the sixth transistor being connected to the second input terminal.

According to an embodiment, the stage circuit further includes a seventh transistor connected between the first power input terminal and the third node, a gate electrode of the seventh transistor being connected to the first node.

According to an embodiment, the stage circuit further includes a sixth transistor connected between the second node and the third node, a gate electrode of the sixth transistor being connected to the first node.

According to an embodiment, the stage circuit further includes an eighth transistor connected between the seventh transistor and the third node, a gate electrode of the eighth transistor being connected to the third input terminal.

According to an embodiment, the stage circuit further includes a sixth transistor connected between the second node and the third node, a gate electrode of the sixth transistor being connected to the second input terminal.

According to an embodiment, the stage circuit further includes an eighth transistor connected between the seventh transistor and the third node, a gate electrode of the eighth transistor being connected to the third input terminal.

According to an embodiment, the stage circuit further includes an eighth transistor connected between the first power input terminal and the seventh transistor, a gate electrode of the eighth transistor being connected to the third input terminal.

According to an embodiment, the stage circuit further includes a sixth transistor connected between the second node and the third node, a gate electrode of the sixth transistor being connected to the second power input terminal.

According to an embodiment, the stage circuit further includes an eighth transistor connected between the first power input terminal and the seventh transistor, a gate electrode of the eighth transistor being connected to the third input terminal.

According to an embodiment, a scan driver for a display device includes a stage circuit which controls a voltage of an output terminal based on voltages of a first node and a second node. The stage circuit includes: a first transistor connected between a first input terminal and a third node, a gate electrode of the first transistor being connected to a second input terminal; a second transistor connected between a first power input terminal and the output terminal, a gate electrode of the second transistor being connected to the first node; a third transistor connected between a third input terminal and the output terminal, a gate electrode of the third transistor being connected to the second node; a fourth transistor connected between the first node and the second input terminal, a gate electrode of the fourth transistor being connected to the third node; a fifth transistor connected between the first node and a second power input terminal, a gate electrode of the fifth transistor being connected to the second input terminal; a sixth transistor connected between the second node and the third node, a gate electrode of the sixth transistor being connected to the second input terminal; an auxiliary transistor connected in parallel to the first transistor across the first input terminal and the third node, a gate electrode of the auxiliary transistor being connected to the third input terminal; a first capacitor connected between the output terminal and the second node; and a second capacitor connected between the first power input terminal and the first node.

According to an embodiment, a display device includes: pixels connected to scan lines and data lines; and a scan driver including a plurality of stage circuits to supply scan signals to the scan lines. One of the plurality of stage circuits includes: a first transistor connected between a first input terminal and a second node, a gate electrode of the first transistor being connected to a second input terminal; a second transistor connected between a first power input terminal and an output terminal, a gate electrode of the second transistor being connected to a first node; a third transistor connected between a third input terminal and the output terminal, a gate electrode of the third transistor being connected to the second node; a fourth transistor connected between the first node and the second input terminal, a gate electrode of the fourth transistor being connected to the second node; and a fifth transistor connected between the first node and a second power input terminal, a gate electrode of the fifth transistor being connected to the second input terminal.

An electronic device according to an embodiment of the present disclosure includes: a processor to provide image data; and a display device to display an image based on the image data. The display device includes: pixels connected to scan lines and data lines; and a scan driver having a plurality of stage circuits to supply scan signals to the scan lines. One of the plurality of stage circuits includes: a first transistor connected between a first input terminal and a second node, a gate electrode of the first transistor being connected to a second input terminal; a second transistor connected between a first power input terminal and an output terminal, a gate electrode of the second transistor being connected to a first node; a third transistor connected between a third input terminal and the output terminal, a gate electrode of the third transistor being connected to the second node; a fourth transistor connected between the first node and the second input terminal, a gate electrode of the fourth transistor being connected to the second node; and a fifth transistor connected between the first node and a second power input terminal, a gate electrode of the fifth transistor being connected to the second input terminal.

### BRIEF DESCRIPTION OF THE DRAWINGS

FIG. 1 is a diagram illustrating a display device according to an embodiment of the present disclosure.
FIG. 2 is a diagram illustrating an embodiment of the scan driver illustrated in FIG. 1.
FIG. 3 is a diagram illustrating an embodiment of the stage circuit illustrated in FIG. 2.
FIG. 4 is a waveform diagram illustrating an embodiment of a method for driving the stage circuit illustrated in FIG. 3.
FIGS. 5A to 5C are diagrams illustrating the operation process of a stage circuit corresponding to the driving method of FIG. 4.
FIG. 6 is a diagram illustrating a stage circuit according to an embodiment of the present disclosure.
FIG. 7 is a diagram illustrating a stage circuit according to an embodiment of the present disclosure.
FIG. 8 is a diagram illustrating a stage circuit according to an embodiment of the present disclosure.
FIG. 9 is a diagram illustrating a stage circuit according to an embodiment of the present disclosure.
FIG. 10 is a diagram illustrating a stage circuit according to an embodiment of the present disclosure.
FIG. 11 is a diagram illustrating a stage circuit according to an embodiment of the present disclosure.
FIG. 12 is a diagram illustrating a stage circuit according to an embodiment of the present disclosure.
FIG. 13 is a diagram illustrating a stage circuit according to an embodiment of the present disclosure.
FIG. 14 is a diagram illustrating a stage circuit according to an embodiment of the present disclosure.
FIG. 15 is a diagram illustrating a stage circuit according to an embodiment of the present disclosure.
FIG. 16 is a diagram illustrating a stage circuit according to an embodiment of the present disclosure.
FIG. 17 is a diagram illustrating a stage circuit according to an embodiment of the present disclosure.
FIG. 18 is a diagram illustrating a stage circuit according to an embodiment of the present disclosure.
FIG. 19 is a diagram illustrating a stage circuit according to an embodiment of the present disclosure.
FIG. 20 is a diagram illustrating a stage circuit according to an embodiment of the present disclosure.
FIG. 21 is a diagram illustrating a stage circuit according to an embodiment of the present disclosure.
FIG. 22 is a diagram illustrating a stage circuit according to an embodiment of the present disclosure.
FIG. 23 is a diagram illustrating a stage circuit according to an embodiment of the present disclosure.
FIG. 24 is a diagram illustrating a stage circuit according to an embodiment of the present disclosure.
FIG. 25 is a diagram illustrating a stage circuit according to an embodiment of the present disclosure.
FIG. 26 is a diagram illustrating a stage circuit according to an embodiment of the present disclosure.
FIG. 27 is a diagram illustrating a stage circuit according to an embodiment of the present disclosure.
FIG. 28 is a diagram illustrating a stage circuit according to an embodiment of the present disclosure.
FIG. 29 is a diagram illustrating a stage circuit according to an embodiment of the present disclosure.
FIG. 30 is a diagram illustrating a stage circuit according to an embodiment of the present disclosure.
FIG. 31 is a diagram illustrating a stage circuit according to an embodiment of the present disclosure.
FIG. 32 is a diagram illustrating a stage circuit according to an embodiment of the present disclosure.
FIG. 33 is a diagram illustrating a stage circuit according to an embodiment of the present disclosure.
FIG. 34 is a diagram illustrating a stage circuit according to an embodiment of the present disclosure.
FIG. 35 is a diagram illustrating a stage circuit according to an embodiment of the present disclosure.
FIG. 36 is a diagram illustrating a stage circuit according to an embodiment of the present disclosure.
FIG. 37 is a diagram illustrating a stage circuit according to an embodiment of the present disclosure.
FIG. 38 is a diagram illustrating a stage circuit according to an embodiment of the present disclosure.
FIG. 39 is a diagram illustrating a stage circuit according to an embodiment of the present disclosure.
FIG. 40 is a diagram illustrating a stage circuit according to an embodiment of the present disclosure.
FIG. 41 is a diagram illustrating a stage circuit according to an embodiment of the present disclosure.
FIG. 42 is a diagram illustrating an electronic device according to an embodiment of the present disclosure.
FIGS. 43 to 46 are exemplary diagrams illustrating electronic devices according to various embodiments.

### DETAILED DESCRIPTION

Hereinafter, various embodiments of the present disclosure will be described in detail with reference to the accompanying drawings so that those skilled in the art may easily implement the present disclosure. However, the present disclosure may be implemented in various different forms and is not limited to the embodiments described herein.

To provide a clear explanation of the present disclosure, parts unrelated to the description are omitted, and identical or similar components are denoted by the same reference numerals throughout the specification. Accordingly, reference numerals described previously may also be used in other drawings.

Further, the expression "the same" or "identical" in the description may refer to "substantially the same" or "substantially identical". In other words, this expression may indicate that two parts are so identical that a person skilled in the art would be convinced that they are identical. Other expressions may also be expressions from which "substantially" is omitted.

Some embodiments are described in the accompanying drawings with respect to functional blocks, units and/or modules. Those skilled in the art will appreciate that these blocks, units and/or modules may be physically implemented by logic circuits, discrete components, microprocessors, hard-wired circuits, memory elements, wiring connections and other electronic circuits. These may be formed using semiconductor-based manufacturing techniques or other manufacturing techniques. In the case of blocks, units and/or modules implemented by microprocessors or other similar hardware, they may be programmed and controlled using software to perform various functions discussed in the present disclosure and may optionally be driven by firmware and/or software. In addition, each block, unit and/or module may be implemented by dedicated hardware or may be implemented by a combination of dedicated hardware performing some functions and processors (e.g., one or more programmed microprocessors and associated circuits) performing other functions. In addition, in some embodiments, the blocks, units and/or modules may be physically separated into two or more individual blocks, units and/or modules that interact with each other without departing from the scope of the inventive concept. Additionally, in some embodiments, blocks, units and/or modules may be combined into physically more complex blocks, units and/or modules without departing from the scope of the present disclosure.

The term "connection" between two components may, but is not necessarily limited to, encompassing both electrical and physical connections. For example, "connection" used in reference to a schematic diagram may mean an electrical connection, while "connection" used in reference to a cross-section or plan view may mean a physical connection.

Although the terms such as first and second are used to describe various components, it is to be understood that these components are not limited by these terms. These terms are merely used to distinguish one component from another. Accordingly, it is to be understood that a first component referred to below may also be a second component within the technical idea of the present disclosure.

Meanwhile, the present disclosure is not limited to the embodiments disclosed below and may be implemented by changing various forms. In addition, each embodiment disclosed below may be implemented alone or may be implemented in a composite manner by combining with at least one other embodiment.

At least one embodiment provides a stage circuit for use in scan drivers of display devices, which optimizes power consumption and reduces the space required for circuit implementation. This stage circuit controls the voltage of an output terminal based on inputs from multiple nodes and incorporates a variety of transistors and capacitors to efficiently manage voltage levels during operation. The design aims to enhance the efficiency and compactness of scan drivers in display devices like LCDs or OLEDs, contributing to overall increased performance in terms of energy usage and device size.

The stage circuit may be designed to control the voltage of an output terminal based on the voltages of a first node and a second node. The circuit may include five transistors configured to dynamically regulate voltage transitions and enable precise signal control. A first transistor connects a first input terminal to a third node, a second transistor links a first power input terminal to the output terminal, and a third transistor connects a third input terminal to the output terminal. Additionally, a fourth transistor bridges the first node and the second input terminal, while a fifth transistor connects the first node to a second power input terminal. During specific periods, the third node is dynamically connected to the second node, enhancing stability, reducing power consumption, and simplifying the circuit design for efficient operation in display scan drivers.

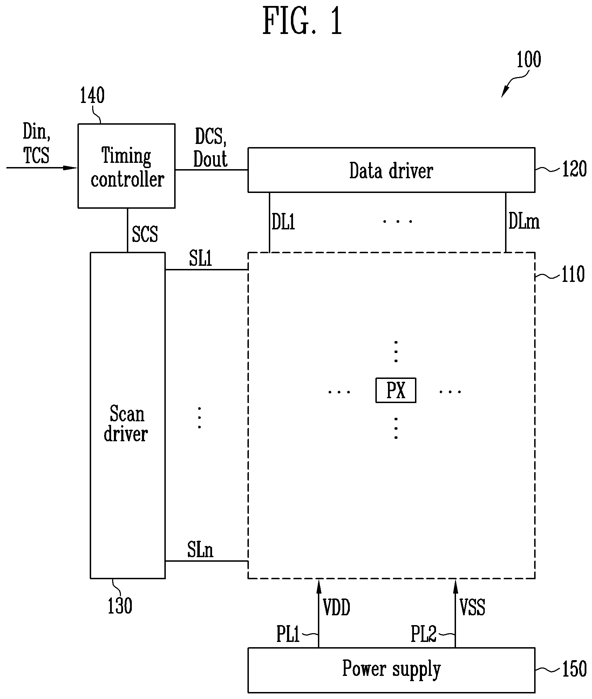

FIG. 1 is a diagram illustrating a display device according to an embodiment of the present disclosure.

Referring to FIG. 1, a display device 100 according to an embodiment of the present disclosure includes a display 110 (e.g., a display panel), a data driver 120 (e.g., a first driver circuit), a scan driver 130 (e.g., a second driver circuit), a timing controller 140 (e.g., a controller circuit), and a power supply 150.

The display 110 may have pixels (PX) connected to scan lines (SL1 to SLn), data lines (DL1 to DLm), and power lines (PL1, PL2) (wherein, n and m are natural numbers greater than or equal to 2).

Pixels (PX) are selected in units of horizontal lines (for example, pixels connected to the same scan line may form one horizontal line) when an enable scan signal (e.g., a scan signal) is supplied to scan lines (SL1 to SLn) and the pixels (PX) selected by the enable scan signal may receive a data signal from a data line (any one of DL1 to DLm) connected thereto. The pixels (PX) supplied with the data signal may generate light of a predetermined brightness in response to the voltage of the data signal. Each of the pixels (PX) may include at least one light-emitting element (not shown) and at least one transistor.

The scan driver 130 may receive a scan drive signal (SCS) from the timing controller 140. The scan drive signal (SCS) may include at least one start signal and clock signals required for driving the scan driver 130. The scan driver 130 may generate an enable scan signal while shifting the start signal in response to the clock signal.

The data driver 120 may receive output data (Dout) and a data drive signal (DCS) from the timing controller 140. The data drive signal (DCS) may include sampling signals and/or timing signals required for driving the data driver 120. The data driver 120 may generate a data signal based on the data drive signal (DCS) and the output data (Dout). For example, the data driver 120 may generate an analog data signal based on the grayscale of the output data (Dout). The data driver 120 may supply a data signal in units of one (1) horizontal period.

The timing controller 140 may receive input data (Din) and a timing control signal (TCS) from the host system through an interface. For example, the timing controller 140 may receive input data (Din) and a timing control signal (TCS) from at least one of a GPU (Graphics Processing Unit), a CPU (Central Processing Unit) and an AP (Application Processor) included in the host system. The timing control signal (TCS) may include various signals including a clock signal.

The timing controller 140 may generate the scan drive signal (SCS) and the data drive signal (DCS) based on the timing control signal (TCS). The scan drive signal (SCS) and the data drive signal (DCS) may be supplied to the scan driver 130 and the data driver 120, respectively.

The timing controller 140 may adjust the input data (Din) to align with the specifications of the display device 100. In addition, the timing controller 140 may correct the input data (Din) to generate output data (Dout) and supply the output data (Dout) to the data driver 120. In an embodiment, the timing controller 140 may correct the input data (Din) in response to optical measurement results measured during a measuring process.

The power supply 150 may generate various power required to drive the display device 100. For example, the power supply 150 may generate a first driving power (VDD) and a second driving power (VSS).

The first driving power (VDD) may be a power source that supplies driving current to the pixels (PX). The second driving power (VSS) may be a power source that receives driving current from the pixels (PX). During a period in which the pixels (PX) emit light, the first driving power (VDD) may have a higher voltage than the second driving power (VSS).

The power supply 150 may be supplied to the first power line (PL1) and the second driving power (VSS) may be supplied to the second power line (PL2). The first power line (PL1) and the second power line (PL2) may be commonly connected to the pixels (PX), but embodiments of the present disclosure are not limited thereto.

In an embodiment, the first power line (PL1) includes a plurality of power lines and the plurality of power lines may be connected to different pixels (PX). In an embodiment, the second power line (PL2) includes a plurality of power lines and the plurality of power lines may be connected to different pixels (PX).

In an embodiment of the present disclosure, the display device 100 may include a flat display device, a curved display device in which a portion of the display 110 is curved, a flexible display device in which a portion can be folded or bent, and a stretchable display device in which a portion can be stretched.

In an embodiment of the present disclosure, the display device 100 is a device that displays a moving image or a still image and may include a portable electronic device such as a mobile phone, a smart phone, a tablet personal computer (PC), a smart watch, a watch phone, a mobile communication terminal, an electronic notebook, an electronic book, a Portable Multimedia Player (PMP), a navigation device, an Ultra Mobile PC (UMPC) and the like. In an embodiment of the present disclosure, the display device 100 may include an electronic device such as a television, a laptop, a monitor, a billboard and an Internet of Things (IoT).

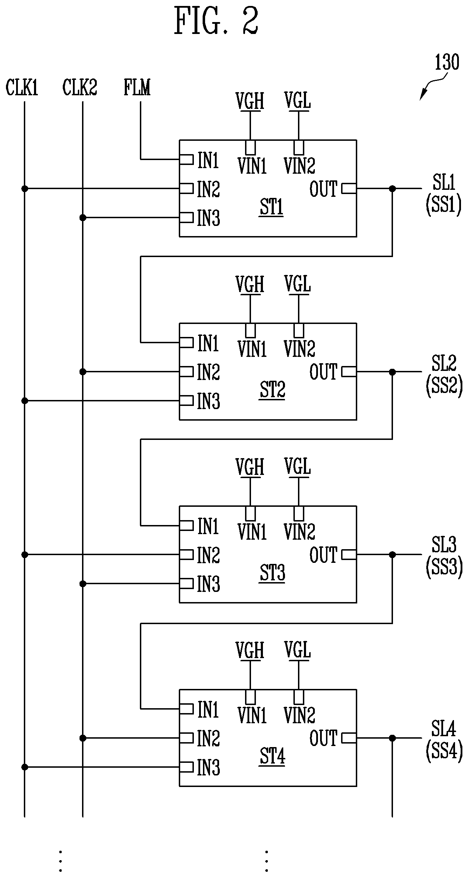

FIG. 2 is a diagram illustrating an embodiment of the scan driver illustrated in FIG. 1. In FIG. 2, four stage circuits are illustrated for convenience of explanation, but the present disclosure is not limited thereto. For example, the scan driver 130 may include n stage circuits, where n is at least two.

Referring to FIG. 2, the scan driver 130 according to the embodiment of the present disclosure may have a plurality of stage circuits (ST1, ST2, ST3, ST4, ...). Each of the stage circuits (ST1, ST2, ST3, ST4, ...) may be connected to any one of the scan lines (SL1, SL2, SL3, SL4, ...). For example, the first stage circuit (ST1) may be connected to the first scan line (SL1), the second stage circuit (ST2) may be connected to the second scan line (SL2), the third stage circuit (ST3) may be connected to the third scan line (SL3) and the fourth stage circuit (ST4) may be connected to the fourth scan line (SL4).

Each of the stage circuits (ST1 to ST4) may include a first input terminal (IN1), a second input terminal (IN2), a third input terminal (IN3), a first power input terminal (VIN1), a second power input terminal (VIN2) and an output terminal (OUT). However, the second power input terminal (VIN2) may be omitted depending on the circuit configuration.

The first input terminal (IN1) may be supplied with a start signal (FLM) or a carry signal from a previous stage circuit. For example, a start signal (FLM) may be input to the first input terminal (IN1) of the first stage circuit (ST1). For example, a carry signal of a previous stage circuit may be input to the first input terminal (IN1) of the second stage circuit (ST2) to the fourth stage circuit (ST4). Here, the carry signal may be a scan signal of the previous stage circuit.

Clock signals (CLK1, CLK2) may be input to the second input terminal (IN2) and the third input terminal (IN3) of each of the stage circuits (ST1 to STn). For example, a first clock signal (CLK1) may be input to the second input terminal (IN2) of odd-numbered stage circuits (ST1, ST3, ...) and a second clock signal (CLK2) may be input to the third input terminal (IN3). For example, a second clock signal (CLK2) may be input to the second input terminal (IN2) of even-numbered stage circuits (ST2, ST4, ...) and a first clock signal (CLK1) may be input to the third input terminal (IN3).

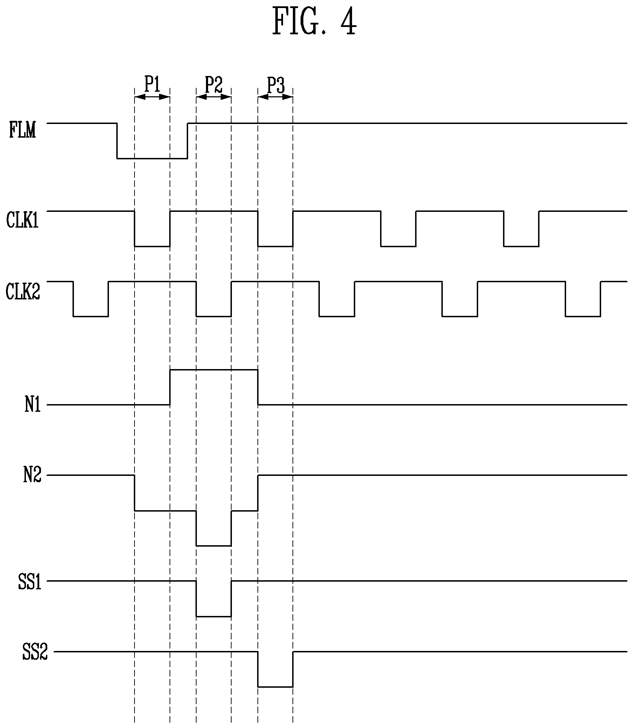

The first clock signal (CLK1) and the second clock signal (CLK2) may be signals having the same period but different phases, as illustrated in FIG. 4. For example, the first clock signal (CLK1) and the second clock signal (CLK2) may have the same period but different phases by 180 degrees.

A first power source (VGH) may be input to a first power input terminal (VIN1) of each of the stage circuits (ST1 to ST4) and a second power source (VGL) may be input to a second power input terminal (VIN2) of each of the stage circuits (ST1 to ST4). The first power source (VGH) may have a logic high level and the second power source (VGL) may have a logic low level. In other words, the second power source (VGL) may have a lower voltage compared to the first power source (VGH).

The output terminal (OUT) of each of the stage circuits (ST1 to ST4) may be electrically connected to any one of the scan lines (SL1, SL2, SL3, SL4). For example, the output terminal (OUT) of the first stage circuit (ST1) may be electrically connected to the first scan line (SL1) and may provide the first scan signal (SS1) to the first scan line (SL1). The output terminal (OUT) of the second stage circuit (ST2) may be electrically connected to the second scan line (SL2) and may provide the second scan signal (SS2) to the second scan line (SL2). The output terminal (OUT) of the third stage circuit (ST3) may be electrically connected to the third scan line (SL3) and may provide the third scan signal (SS3) to the third scan line (SL3). The output terminal (OUT) of the fourth stage circuit (ST4) may be electrically connected to the fourth scan line (SL4) and may provide the fourth scan signal (SS4) to the fourth scan line (SL4).

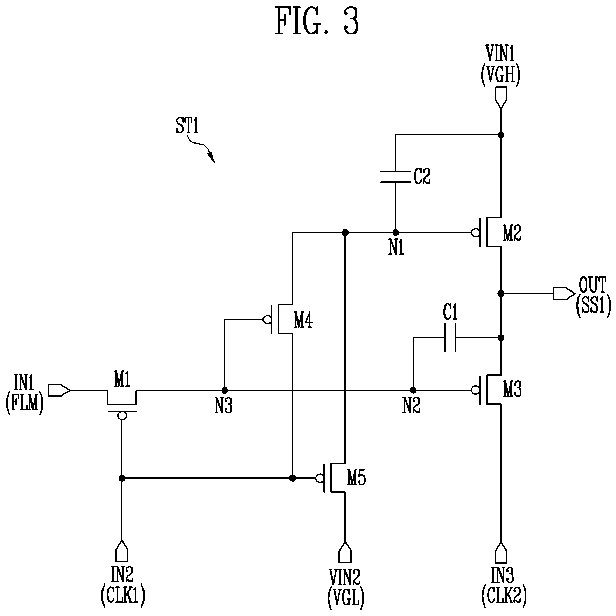

FIG. 3 is a diagram illustrating an embodiment of the stage circuit illustrated in FIG. 2. In FIG. 3, a first stage circuit (ST1) is illustrated for convenience of explanation and the remaining stage circuits (ST2, ST3, ST4, ...) may be configured substantially identically to the first stage circuit (ST1).

Referring to FIG. 3, a stage circuit (ST1) according to an embodiment of the present disclosure includes a first transistor (M1), a second transistor (M2), a third transistor (M3), a fourth transistor (M4), a fifth transistor (M5), a first capacitor (C1) and a second capacitor (C2).

A first transistor (M1) may be connected between a first input terminal (IN1) and a third node (N3). Further, a gate electrode of the first transistor (M1) may be connected to a second input terminal (IN2). Such a first transistor (M1) may control an electrical connection between the first input terminal (IN1) and the third node (N3) in response to a first clock signal (CLK1) input to the second input terminal (IN2).

The second transistor (M2) may be connected between the first power input terminal (VIN1) and the output terminal (OUT). Further, a gate electrode of the second transistor (M2) may be connected to the first node (N1). Such a second transistor (M2) may control the electrical connection between the first power input terminal (VIN1) and the output terminal (OUT) in response to the voltage of the first node (N1).

A third transistor (M3) may be connected between an output terminal (OUT) and a third input terminal (IN3). In addition, a gate electrode of the third transistor (M3) may be connected to a second node (N2). Such a third transistor (M3) may control an electrical connection between the third input terminal (IN3) and the output terminal (OUT) in response to the voltage of the second node (N2).

The fourth transistor (M4) may be connected between the first node (N1) and the second input terminal (IN2). Further, a gate electrode of the fourth transistor (M4) may be connected to the third node (N3). Here, the third node (N3) is a node electrically connected to the second node (N2) and may be substantially the same node. The fourth transistor (M4) may control the electrical connection between the first node (N1) and the second input terminal (IN2) in response to the voltage of the third node (N3).

The fifth transistor (M5) may be connected between the first node (N1) and the second power input terminal (VIN2). Further, a gate electrode of the fifth transistor (M5) may be connected to the second input terminal (IN2). The fifth transistor (M5) may control the electrical connection between the first node (N1) and the second power input terminal (VIN2) in response to the first clock signal (CLK1) input to the second input terminal (IN2).

A first capacitor (C1) may be connected between an output terminal (OUT) and a second node (N2). The first capacitor (C1) may control the voltage of the second node (N2) in response to the voltage of the output terminal (OUT).

A second capacitor (C2) may be connected between the first power input terminal (VIN1) and the first node (N1). The second capacitor (C2) may store a voltage between the first power input terminal (VIN1) and the first node (N1).

In an embodiment of the present disclosure, the stage circuit (ST1) may include five transistors (M1 to M5) and two capacitors (C1, C2). In this case, the mounting area of the stage circuit (ST1) may be minimized.

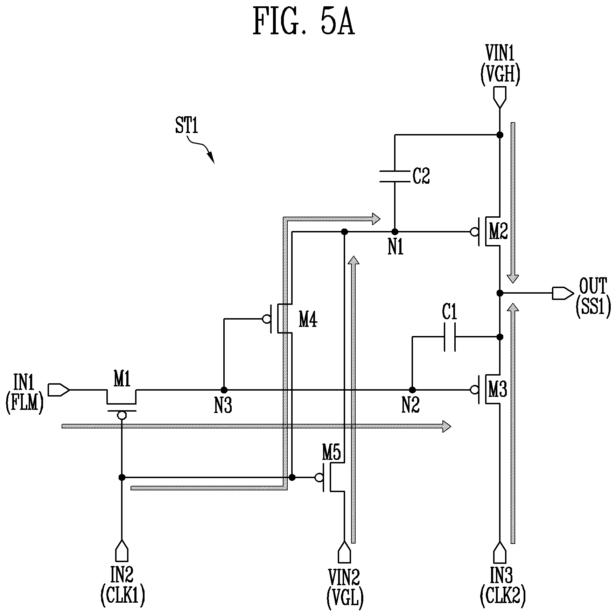

FIG. 4 is a waveform diagram illustrating an embodiment of a driving method of the stage circuit shown in FIG. 3. FIGS. 5A to 5C are diagrams illustrating the operation process of the stage circuit corresponding to the driving method of FIG. 4.

Referring to FIG. 4 and 5A, a low-level start signal (FLM) may be input to the first input terminal (IN1) so as to be synchronized with a low-level first clock signal (CLK1) input to the second input terminal (IN2) during the first period (P1).

When a low-level first clock signal (CLK1) is input to the second input terminal (IN2), the first transistor (M1) and the fifth transistor (M5) may be turned on. When the first transistor (M1) is turned on, a low-level start signal (FLM) may be supplied to the third node (N3) and the second node (N2). When a low-level start signal (FLM) (e.g., a low-level voltage) is input to the second node (N2) and the third node (N3), the third transistor (M3) and the fourth transistor (M4) may be turned on.

When the third transistor (M3) is turned on, the third input terminal (IN3) and the output terminal (OUT) may be electrically connected to one another. During the first period (P1), a high-level second clock signal (CLK2) is input to the third input terminal (IN3) and accordingly, a high-level voltage may be supplied to the output terminal (OUT). In an embodiment, the voltage of the high-level second clock signal (CLK2) is substantially the same voltage as the first power source (VGH).

When the fourth transistor (M4) is turned on, a low-level first clock signal (CLK1) (e.g., a low-level voltage) may be supplied from the second input terminal (IN2) to the first node (N1). In an embodiment, the voltage of the low-level first clock signal (CLK1) is substantially the same voltage as the second power source (VGL).

When the fifth transistor (M5) is turned on, the second power source (VGL) may be supplied from the second power input terminal (VIN2) to the first node (N1). When the voltage (e.g., a low level voltage) of the second power source (VGL) is input to the first node (N1), the second transistor (M2) may be turned on.

When the second transistor (M2) is turned on, the first power input terminal (VIN1) and the output terminal (OUT) become electrically connected to one another. Thus the voltage of the first power source (VGH) may be supplied to the output terminal (OUT).

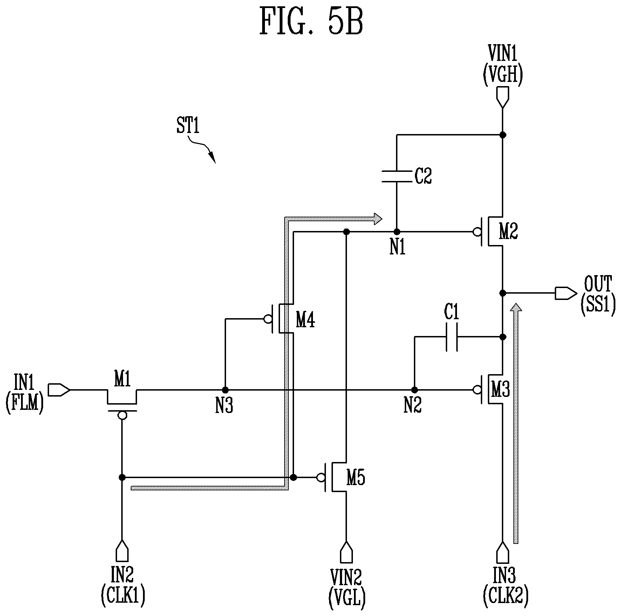

Referring to FIGS. 4 and 5B, a high level voltage may be input to a first input terminal (IN1) during a second period (P2). In addition, a high level first clock signal (CLK1) may be input to a second input terminal (IN2) during the second period (P2) and a low level second clock signal (CLK2) may be input to a third input terminal (IN3).

During the second period (P2), the second node (N2) and the third node (N3) may maintain a low level voltage due to the first capacitor (C1). Accordingly, the third transistor (M3) and the fourth transistor (M4) may maintain a turned-on state during the second period (P2).

When the fourth transistor (M4) is turned on, a high level first clock signal (CLK1) input to the second input terminal (IN2) may be supplied to the first node (N1). Then, the first node (N1) may have a high level voltage during the second period (P2) and thus the second transistor (M2) may be turned off.

When the third transistor (M3) is turned on, the low level second clock signal (CLK2) input to the third input terminal (IN3) may be supplied to the output terminal (OUT). The low level second clock signal (CLK2) input to the output terminal (OUT) may be supplied to the scan line (SL1) as an enable scan signal (SS1).

Meanwhile, when a low-level second clock signal (CLK2) is supplied to the output terminal (OUT), the coupling of the first capacitor (C1) may cause the voltages at the second node (N2) and the third node (N3) to drop below a voltage of the second power source (VGL). For example, during the second period (P2), the voltages at the second node (N2) and the third node (N3) may drop to a level that is approximately half the voltage of the second power source (VGL).

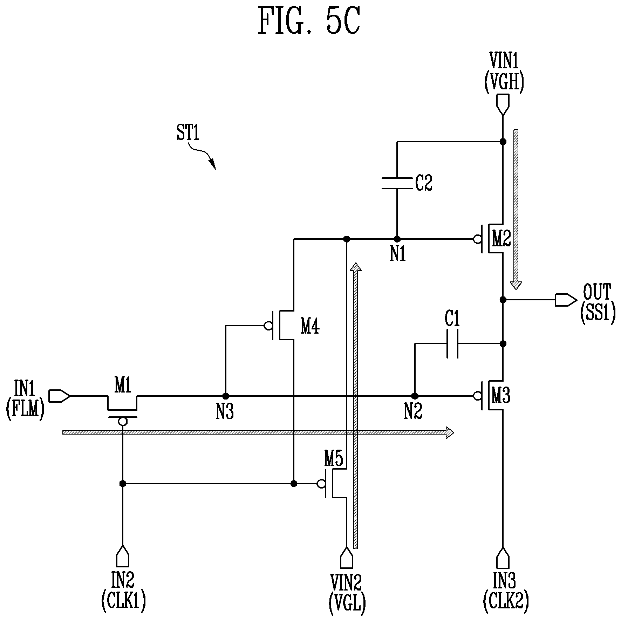

Referring to FIG. 4 and FIG. 5C, a high level voltage may be input to a first input terminal (IN1) during a third period (P3). In addition, a low level first clock signal (CLK1) may be input to a second input terminal (IN2) during the third period (P3) and a high level second clock signal (CLK2) may be input to a third input terminal (IN3).

When a low level first clock signal (CLK1) is input to the second input terminal (IN2), the first transistor (M1) and the fifth transistor (M5) may be turned on. When the first transistor (M1) is turned on, a high level voltage may be supplied to the third node (N3) and the second node (N2). When a high level voltage is input to the second node (N2) and the third node (N3), the third transistor (M3) and the fourth transistor (M4) may be turned off.

When the fifth transistor (M5) is turned on, the voltage of the second power source (VGL) may be supplied to the first node (N1). When the voltage of the second power source (VGL) is input to the first node (N1), the second transistor (M2) may be turned on. When the second transistor (M2) is turned on, the voltage of the first power source (VGH) may be supplied to the output terminal (OUT).

Thereafter, whenever a low-level first clock signal (CLK1) is input, the first transistor (M1) and the fifth transistor (M5) are turned on and accordingly, the second node (N2) and the third node (N2) may maintain a high-level voltage and the first node (N1) may maintain a low-level voltage (e.g., the voltage of the second power source (VGL)).

Meanwhile, the scan signal (SS1) output during the second period (P2) may be supplied to the second stage circuit (ST2) so as to be synchronized with the low-level second clock signal (CLK2). Then, the second stage circuit (ST2) may output the second scan signal (SS2) during the third period (P3). The stage circuits according to the embodiments of the present disclosure, may continuously repeat the aforementioned process to output the scan signal to the scan lines.

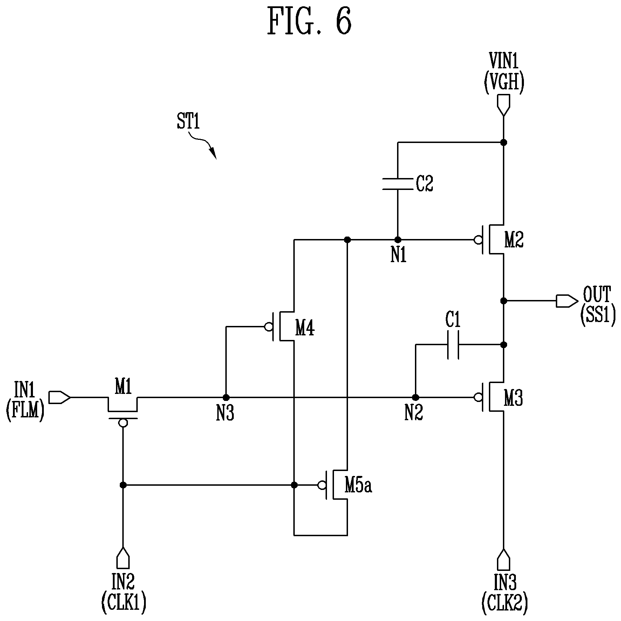

FIG. 6 is a diagram illustrating a stage circuit according to an embodiment of the present disclosure. In FIG. 6, components that are the same as those in FIG. 3 are marked with the same reference numerals, and repetitive descriptions are omitted.

Referring to FIG. 6, a stage circuit (ST1) according to an embodiment of the present disclosure includes a first transistor (M1), a second transistor (M2), a third transistor (M3), a fourth transistor (M4), a fifth transistor (M5a), a first capacitor (C1) and a second capacitor (C2).

The first electrode of the fifth transistor (M5a) may be connected to the first node (N1) and the second electrode and the gate electrode may be connected to the second input terminal (IN2). In other words, the fifth transistor (M5a) may be connected in a diode form so that current may flow from the first node (N1) to the second input terminal (IN2).

The fifth transistor (M5a) may be turned on when a low-level first clock signal (CLK1) is input to the second input terminal (IN2) to lower the voltage of the first node (N1) to approximately the voltage of the low-level first clock signal (CLK1). For example, the fifth transistor (M5a) may be turned on during the first period (P1) and the third period (P3) illustrated in FIG. 4 to reduce and stabilize the voltage at the first node (N1) to a low-level.

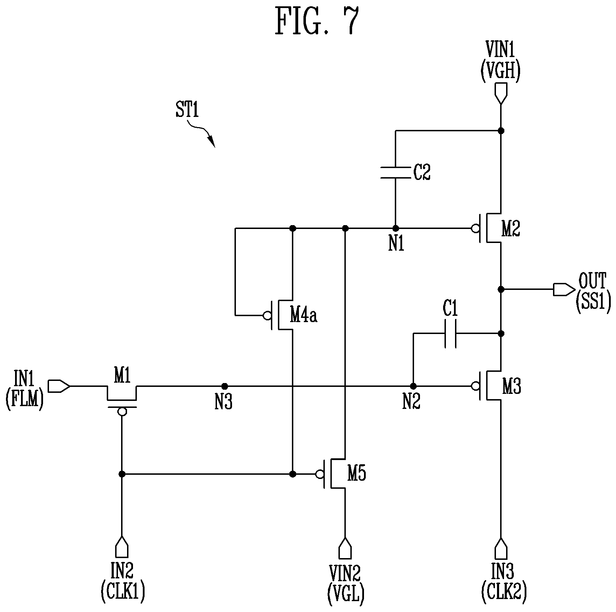

FIG. 7 is a diagram illustrating a stage circuit according to an embodiment of the present disclosure. In FIG. 7, the same reference numerals are assigned to components that are substantially the same as those in FIG. 3 and redundant descriptions are omitted.

Referring to FIG. 7, a stage circuit (ST1) according to an embodiment of the present disclosure includes a first transistor (M1), a second transistor (M2), a third transistor (M3), a fourth transistor (M4a), a fifth transistor (M5), a first capacitor (C1) and a second capacitor (C2).

The first electrode of the fourth transistor (M4a) may be connected to the second input terminal (IN2) and the second electrode and the gate electrode may be connected to the first node (N1). In other words, the fourth transistor (M4a) may be connected in a diode-like manner, allowing current to flow from the second input terminal (IN2) to the first node (N1).

The fourth transistor (M4a) is turned on when a high-level first clock signal (CLK1) is input to the second input terminal (IN2) to increase the voltage of the first node (N1) to approximately the voltage of the high-level first clock signal (CLK1). For example, the fourth transistor (M4a) is turned on during the second period (P2) illustrated in FIG. 4 to increase the voltage of the first node (N1) to a high-level voltage.

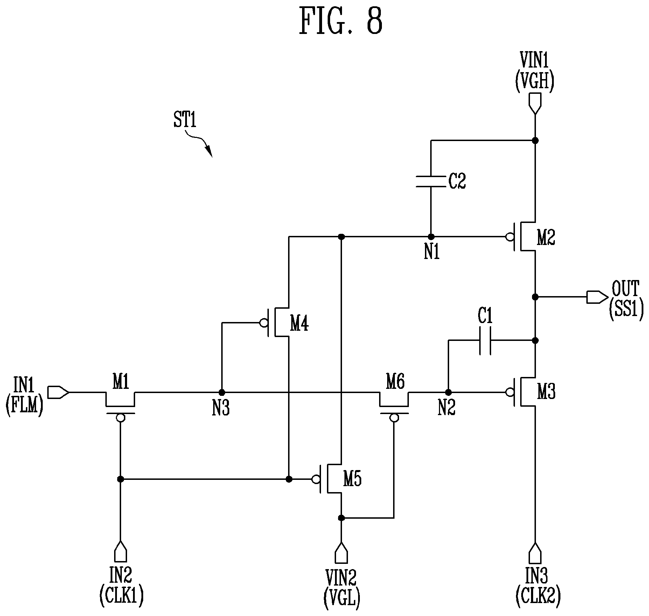

FIG. 8 is a diagram illustrating a stage circuit according to an embodiment of the present disclosure. In FIG. 8, the same reference numerals are assigned to components substantially identical to those in FIG. 3 and redundant descriptions are omitted.

Referring to FIG. 8, a stage circuit (ST1) according to an embodiment of the present disclosure includes a first transistor (M1), a second transistor (M2), a third transistor (M3), a fourth transistor (M4), a fifth transistor (M5), a sixth transistor (M6), a first capacitor (C1) and a second capacitor (C2).

The sixth transistor (M6) may be connected between the second node (N2) and the third node (N3). In addition, a gate electrode of the sixth transistor (M6) may be connected to the second power input terminal (VIN2). Such sixth transistor (M6) may be turned on by the second power source (VGL) input to the second power input terminal (VIN2).

The sixth transistor (M6) may prevent the voltage of the third node (N3) from dropping to a voltage lower than the second power source (VGL) in response to the voltage drop at the second node (N2). For example, as illustrated in FIG. 4, the voltage at the second node (N2) may drop to a voltage lower than the second power source (VGL) during the second period (P2). The voltage of the second power source (VGL) is input to the gate electrode of the sixth transistor (M6) and accordingly, the voltage of the third node (N3) may maintain a voltage higher than the second power source (VGL) regardless of the second node (N2).

When the third node (N3) maintains a voltage higher than the second power source (VGL), a high voltage difference may be prevented from being applied across the first electrode and the second electrode of the first transistor (M1), thereby ensuring driving stability.

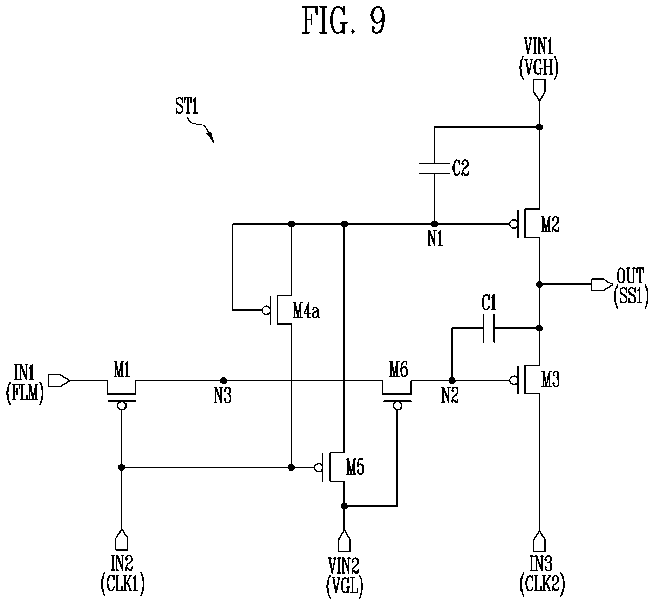

FIG. 9 is a diagram illustrating a stage circuit according to an embodiment of the present disclosure. In FIG. 9, the same reference numerals are assigned to components that are substantially the same as those in FIG. 7 and redundant descriptions are omitted.

Referring to FIG. 9, a stage circuit (ST1) according to an embodiment of the present disclosure includes a first transistor (M1), a second transistor (M2), a third transistor (M3), a fourth transistor (M4a), a fifth transistor (M5), a sixth transistor (M6), a first capacitor (C1) and a second capacitor (C2).

The stage circuit (ST1) of FIG. 9 may have the same configuration as the stage circuit of FIG. 7 except that it additionally includes a sixth transistor (M6). Since the sixth transistor (M6) has been described with reference to FIG. 8, a detailed description thereof will be omitted.

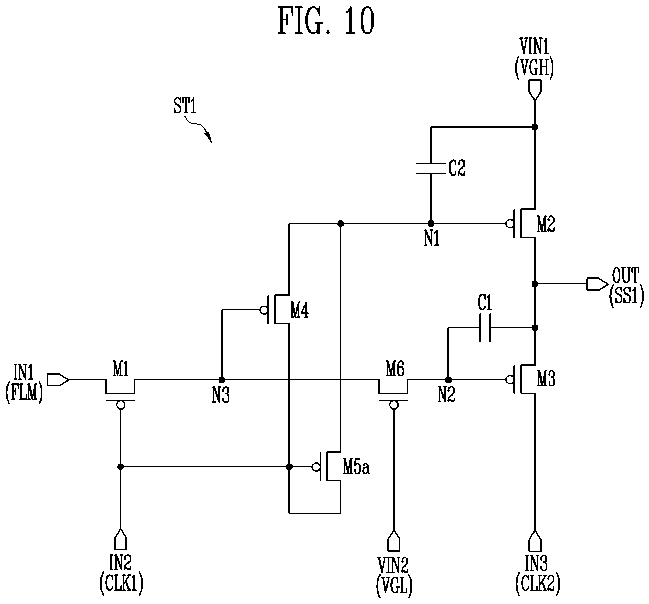

FIG. 10 is a diagram illustrating a stage circuit according to an embodiment of the present disclosure. In FIG. 10, the same reference numerals are assigned to components that are substantially the same as those in FIG. 6 and redundant descriptions are omitted.

Referring to FIG. 10, a stage circuit (ST1) according to an embodiment of the present disclosure includes a first transistor (M1), a second transistor (M2), a third transistor (M3), a fourth transistor (M4), a fifth transistor (M5a), a sixth transistor (M6), a first capacitor (C1) and a second capacitor (C2).

FIG. 10 may have the same configuration as the stage circuit of FIG. 6 except that it additionally includes a sixth transistor (M6). Since the sixth transistor (M6) has been described with reference to FIG. 8, a detailed description thereof will be omitted.

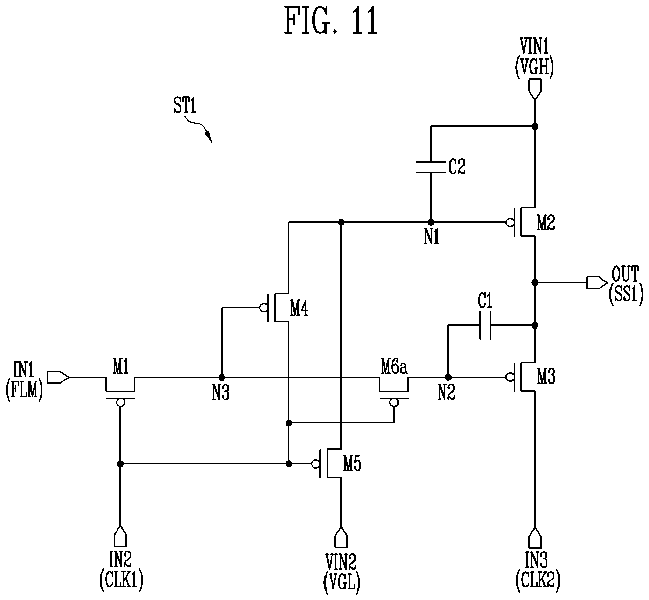

FIG. 11 is a diagram illustrating a stage circuit according to an embodiment of the present disclosure. In FIG. 11, the same reference numerals are assigned to components that are substantially the same as those in FIG. 3 and redundant descriptions are omitted.

Referring to FIG. 11, a stage circuit (ST1) according to an embodiment of the present disclosure includes a first transistor (M1), a second transistor (M2), a third transistor (M3), a fourth transistor (M4), a fifth transistor (M5), a sixth transistor (M6a), a first capacitor (C1) and a second capacitor (C2).

The sixth transistor (M6a) may be connected between the second node (N2) and the third node (N3). In addition, the gate electrode of the sixth transistor (M6a) may be connected to the second input terminal (IN2). The sixth transistor (M6a) may control the electrical connection between the second node (N2) and the third node (N3), switching on or off based on a first clock signal (CLK1) received at the second input terminal (IN2).

The sixth transistor (M6a) is turned on by the low-level first clock signal (CLK1) during the first period (P1) illustrated in FIG. 4 and accordingly, the third node (N3) and the second node (N2) may be electrically connected to one another during the first period (P1). Then, the voltage of the low-level start signal (FLM) input to the first input terminal (IN1) during the first period (P1) may be supplied to the second node (N2) via the third node (N3). In other words, the second node (N2) may be electrically connected to the third node (N3) during at least a portion of the period during which the first transistor (M1) is turned on.

The sixth transistor (M6a) may be turned off by the high level first clock signal (CLK1) during the second period (P2) illustrated in FIG. 4. When the sixth transistor (M6a) is turned off, a voltage lower than the second power source (VGL) applied to the second node (N2) during the second period (P2) is not supplied to the third node (N3). When the third node (N3) maintains a voltage higher than the second power source (VGL), a high voltage difference may be prevented from being applied to both ends of the first electrode and the second electrode of the first transistor (M1), thereby advantageously ensuring driving stability.

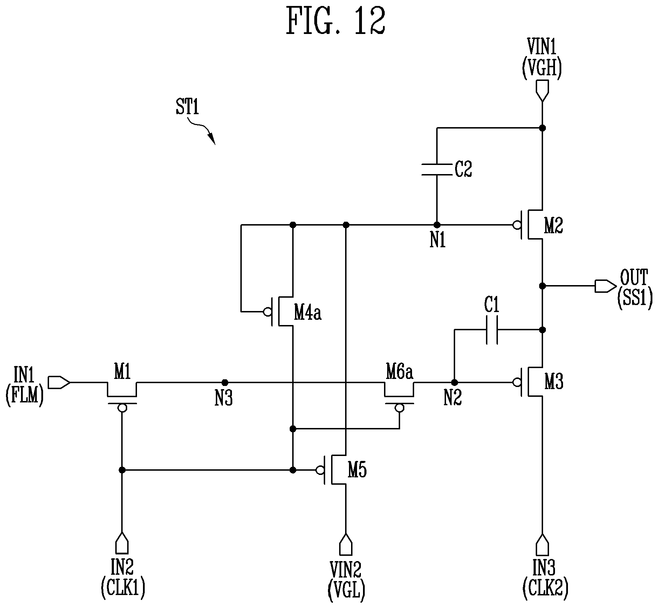

FIG. 12 is a diagram illustrating a stage circuit according to an embodiment of the present disclosure. In FIG. 12, the same reference numerals are assigned to components that are substantially the same as those in FIG. 7 and redundant descriptions are omitted.

Referring to FIG. 12, a stage circuit (ST1) according to an embodiment of the present disclosure includes a first transistor (M1), a second transistor (M2), a third transistor (M3), a fourth transistor (M4a), a fifth transistor (M5), a sixth transistor (M6a), a first capacitor (C1) and a second capacitor (C2).

The stage circuit (ST1) of FIG. 12 may have the same configuration as the stage circuit of FIG. 7 except that it additionally includes a sixth transistor (M6a). Since the sixth transistor (M6a) has been described with reference to FIG. 11, a detailed description thereof will be omitted.

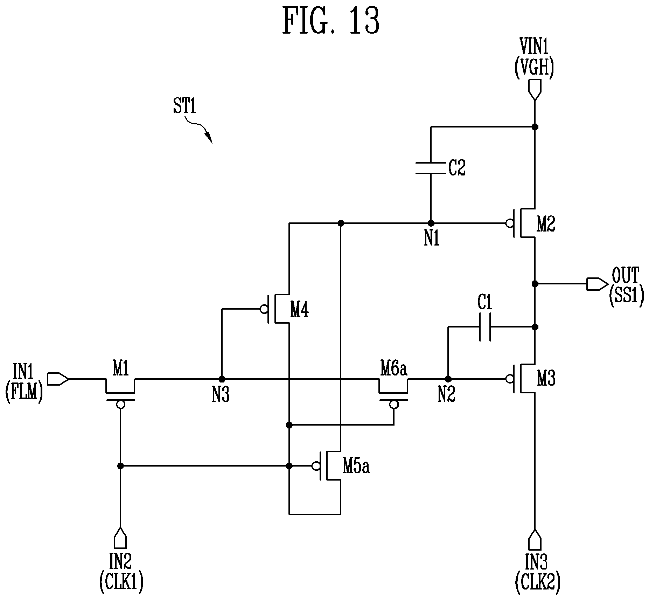

FIG. 13 is a diagram illustrating a stage circuit according to an embodiment of the present disclosure. In FIG. 13, the same reference numerals are assigned to components that are substantially the same as those in FIG. 6 and redundant descriptions are omitted.

Referring to FIG. 13, a stage circuit (ST1) according to an embodiment of the present disclosure includes a first transistor (M1), a second transistor (M2), a third transistor (M3), a fourth transistor (M4), a fifth transistor (M5a), a sixth transistor (M6a), a first capacitor (C1) and a second capacitor (C2).

The stage circuit (ST1) of FIG. 13 may have the same configuration as the stage circuit of FIG. 6 except that it additionally includes a sixth transistor (M6a). Since the sixth transistor (M6a) has been described with reference to FIG. 11, a detailed description thereof will be omitted.

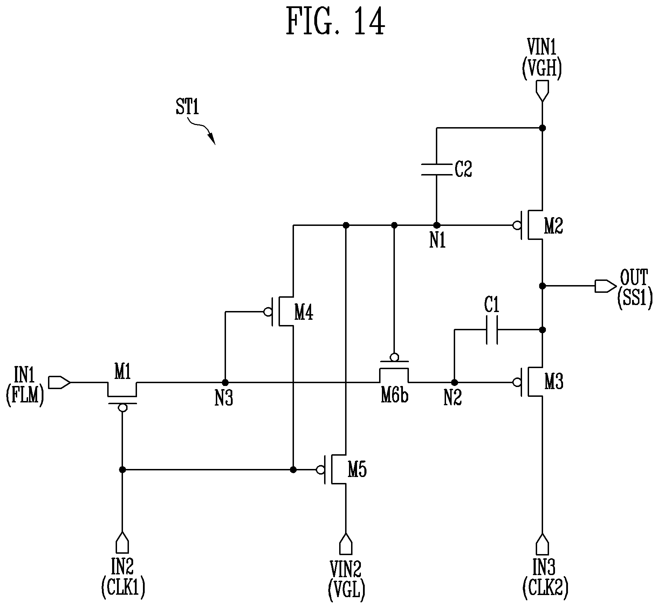

FIG. 14 is a diagram illustrating a stage circuit according to an embodiment of the present disclosure. In FIG. 14, the same reference numerals are assigned to components that are substantially the same as those in FIG. 3 and redundant descriptions are omitted.

Referring to FIG. 14, a stage circuit (ST1) according to an embodiment of the present disclosure includes a first transistor (M1), a second transistor (M2), a third transistor (M3), a fourth transistor (M4), a fifth transistor (M5), a sixth transistor (M6b), a first capacitor (C1) and a second capacitor (C2).

The sixth transistor (M6b) may be connected between the second node (N2) and the third node (N3). In addition, the gate electrode of the sixth transistor (M6b) may be connected to the first node (N1). The sixth transistor (M6b) may control the electrical connection between the second node (N2) and the third node (N3), turning on or off in response to the voltage at the first node (N1).

The sixth transistor (M6b) is turned on by the low level voltage applied to the first node (N1) during the first period (P1) illustrated in FIG. 4 and accordingly, the third node (N3) and the second node (N2) may be electrically connected to one another during the first period (P1). Then, the voltage of the low level start signal (FLM) input to the first input terminal (IN1) during the first period (P1) may be supplied to the second node (N2) via the third node (N3).

The sixth transistor (M6b) may be turned off by a high level voltage during the second period (P2) illustrated in FIG. 4. When the sixth transistor (M6b) is turned off, a voltage lower than the second power source (VGL) applied to the second node (N2) during the second period (P2) is not supplied to the third node (N3). When the third node (N3) maintains a voltage higher than the second power source (VGL), a high voltage difference may be prevented from being applied to both ends of the first electrode and the second electrode of the first transistor (M1), thereby ensuring driving stability.

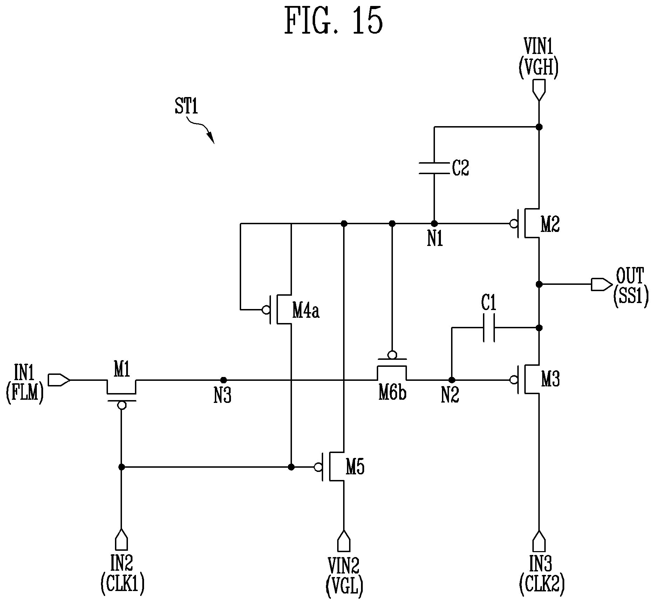

FIG. 15 is a diagram illustrating a stage circuit according to an embodiment of the present disclosure. In FIG. 15, the same reference numerals are assigned to components that are substantially the same as those in FIG. 7 and redundant descriptions are omitted.

Referring to FIG. 15, a stage circuit (ST1) according to an embodiment of the present disclosure includes a first transistor (M1), a second transistor (M2), a third transistor (M3), a fourth transistor (M4a), a fifth transistor (M5), a sixth transistor (M6b), a first capacitor (C1) and a second capacitor (C2).

The stage circuit (ST1) of FIG. 15 may have the same configuration as the stage circuit of FIG. 7 except that it additionally includes a sixth transistor (M6b). Since the sixth transistor (M6b) has been described with reference to FIG. 14, a detailed description thereof will be omitted.

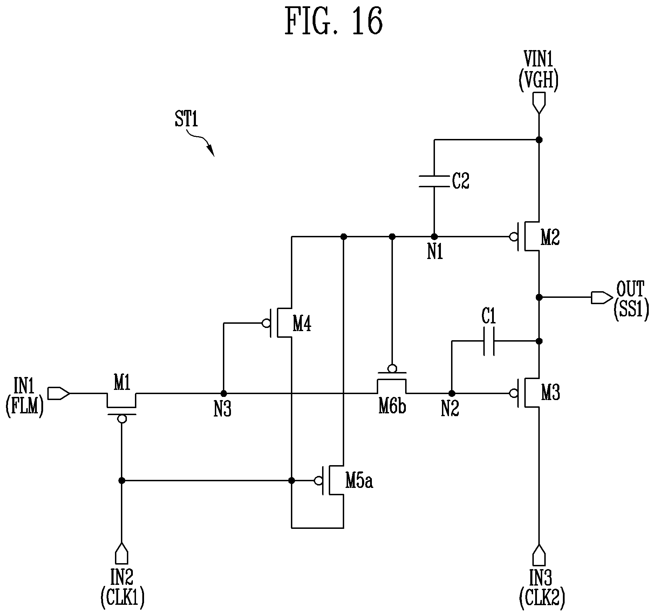

FIG. 16 is a diagram illustrating a stage circuit according to an embodiment of the present disclosure. In FIG. 16, the same reference numerals are assigned to components that are substantially the same as those in FIG. 6 and redundant descriptions are omitted.

Referring to FIG. 16, a stage circuit (ST1) according to an embodiment of the present disclosure includes a first transistor (M1), a second transistor (M2), a third transistor (M3), a fourth transistor (M4), a fifth transistor (M5a), a sixth transistor (M6b), a first capacitor (C1) and a second capacitor (C2).

The stage circuit (ST1) of FIG. 16 may have the same configuration as the stage circuit of FIG. 6 except that it additionally includes a sixth transistor (M6b). Since the sixth transistor (M6b) has been described with reference to FIG. 14, a detailed description thereof will be omitted.

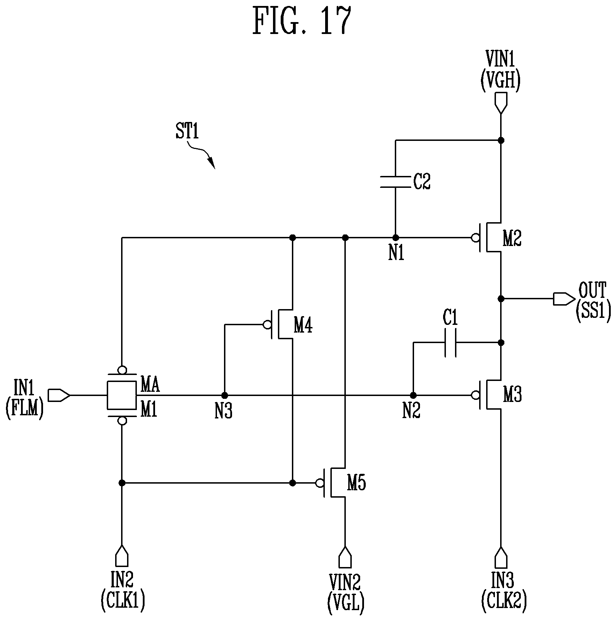

FIG. 17 is a diagram illustrating a stage circuit according to an embodiment of the present disclosure. In FIG. 17, the same reference numerals are assigned to components that are substantially the same as those in FIG. 3 and redundant descriptions are omitted.

Referring to FIG. 17, a stage circuit (ST1) according to an embodiment of the present disclosure includes a first transistor (M1), a second transistor (M2), a third transistor (M3), a fourth transistor (M4), a fifth transistor (M5), an auxiliary transistor (MA), a first capacitor (C1) and a second capacitor (C2).

The auxiliary transistor (MA) may be connected between the first input terminal (IN1) and the third node (N3). For example, the auxiliary transistor (MA) may be connected in parallel to the first transistor (M1) across the first input terminal (IN1) and the third node (N3). A gate electrode of the auxiliary transistor (MA) may be connected to the first node (N1). The auxiliary transistor (MA) may be turned on or off in response to the voltage of the first node (N1).

As illustrated in FIG. 4, the first node (N1) may have a high level voltage during the second period (P2) and may maintain a low level voltage during other periods. During the second period (P2), the auxiliary transistor (MA) is turned off and accordingly, the second node (N2) and the third node (N3) may stably maintain a low level voltage during the second period (P2).

During a period other than the second period (P2), the auxiliary transistor (MA) may be maintained in a turned-on state by the low-level voltage of the first node (N1). When the voltage of the first node (N1) maintains the low-level voltage, the voltage of the third node (N3) may be stably maintained by a parasitic capacitor (not shown) included in the auxiliary transistor (MA). For example, the parasitic capacitor of the auxiliary transistor (MA) may be located between the first node (N1) and the third node (N3) and may prevent the voltage of the third node (N3) from changing when the voltage of the first node (N1) maintains the low-level voltage (for example, when maintaining a constant voltage).

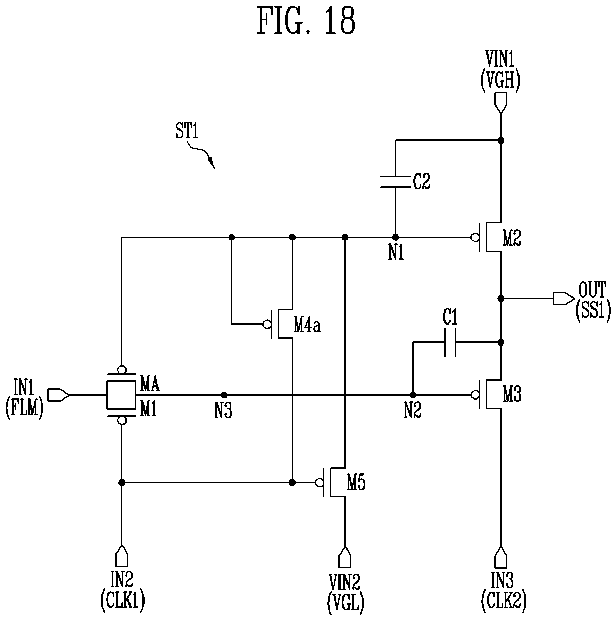

FIG. 18 is a diagram illustrating a stage circuit according to an embodiment of the present disclosure. In FIG. 18, the same reference numerals are assigned to components substantially identical to those in FIG. 7 and redundant descriptions are omitted.

Referring to FIG. 18, a stage circuit (ST1) according to an embodiment of the present disclosure includes a first transistor (M1), a second transistor (M2), a third transistor (M3), a fourth transistor (M4a), a fifth transistor (M5), an auxiliary transistor (MA), a first capacitor (C1) and a second capacitor (C2).

The stage circuit (ST1) of FIG. 18 may have the same configuration as the stage circuit of FIG. 7 except that it additionally includes an auxiliary transistor (MA). Since the auxiliary transistor (MA) has been described with reference to FIG. 17, a detailed description thereof will be omitted.

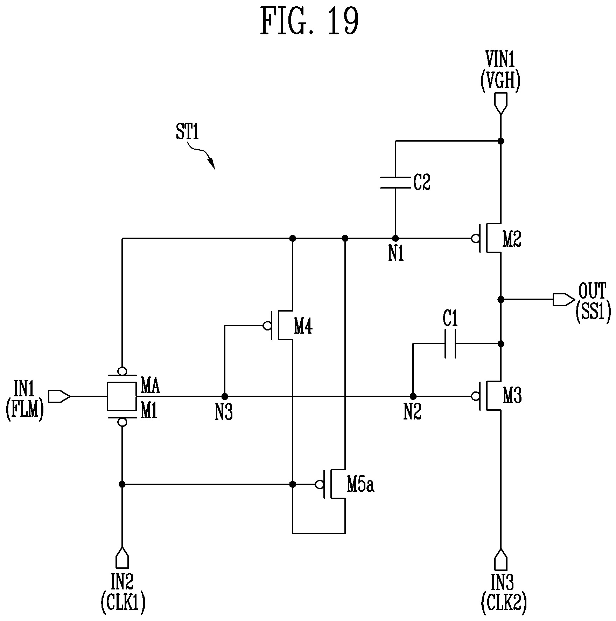

FIG. 19 is a diagram illustrating a stage circuit according to an embodiment of the present disclosure. In FIG. 19, the same reference numerals are assigned to components substantially identical to those in FIG. 6 and redundant descriptions are omitted.

Referring to FIG. 19, a stage circuit (ST1) according to an embodiment of the present disclosure includes a first transistor (M1), a second transistor (M2), a third transistor (M3), a fourth transistor (M4), a fifth transistor (M5a), an auxiliary transistor (MA), a first capacitor (C1) and a second capacitor (C2).

The stage circuit (ST1) of FIG. 19 may have the same configuration as the stage circuit of FIG. 6 except that it additionally includes an auxiliary transistor (MA). Since the auxiliary transistor (MA) has been described with reference to FIG. 17, a detailed description thereof will be omitted.

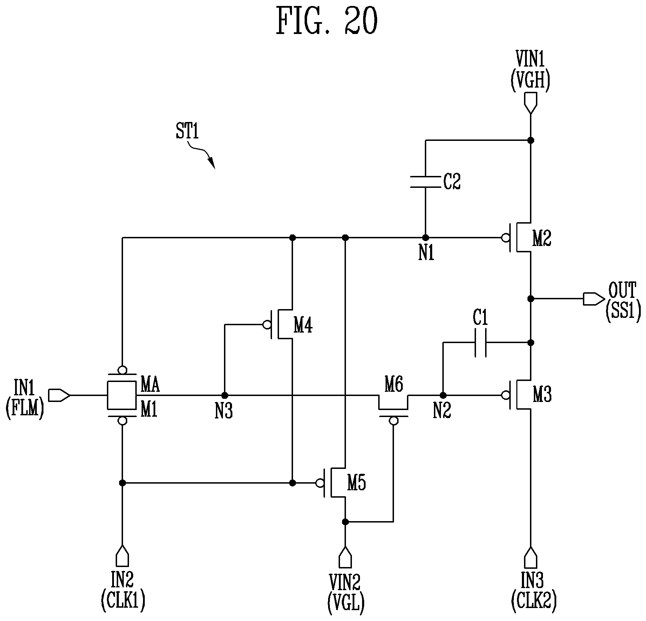

FIG. 20 is a diagram illustrating a stage circuit according to an embodiment of the present disclosure. In FIG. 20, the same reference numerals are assigned to components that are substantially the same as those in FIG. 17 and redundant descriptions are omitted.

Referring to FIG. 20, a stage circuit (ST1) according to an embodiment of the present disclosure includes a first transistor (M1), a second transistor (M2), a third transistor (M3), a fourth transistor (M4), a fifth transistor (M5), a sixth transistor (M6), an auxiliary transistor (MA), a first capacitor (C1) and a second capacitor (C2).

The sixth transistor (M6) is connected between the second node (N2) and the third node (N3) and the gate electrode may be connected to the second power input terminal (VIN2). The sixth transistor (M6) may prevent the voltage of the third node (N3) from dropping below the second power source (VGL).

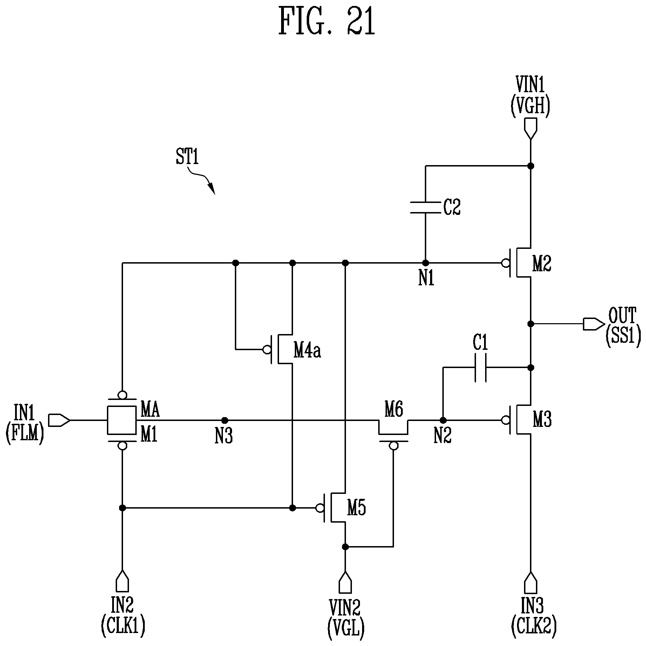

FIG. 21 is a diagram illustrating a stage circuit according to an embodiment of the present disclosure. In FIG. 21, the same reference numerals are assigned to components substantially identical to those in FIG. 18 and redundant descriptions are omitted.

Referring to FIG. 21, a stage circuit (ST1) according to an embodiment of the present disclosure includes a first transistor (M1), a second transistor (M2), a third transistor (M3), a fourth transistor (M4a), a fifth transistor (M5), a sixth transistor (M6), an auxiliary transistor (MA), a first capacitor (C1) and a second capacitor (C2).

The sixth transistor (M6) is connected between the second node (N2) and the third node (N3) and the gate electrode may be connected to the second power input terminal (VIN2). The sixth transistor (M6) may prevent the voltage of the third node (N3) from dropping below the second power source (VGL).

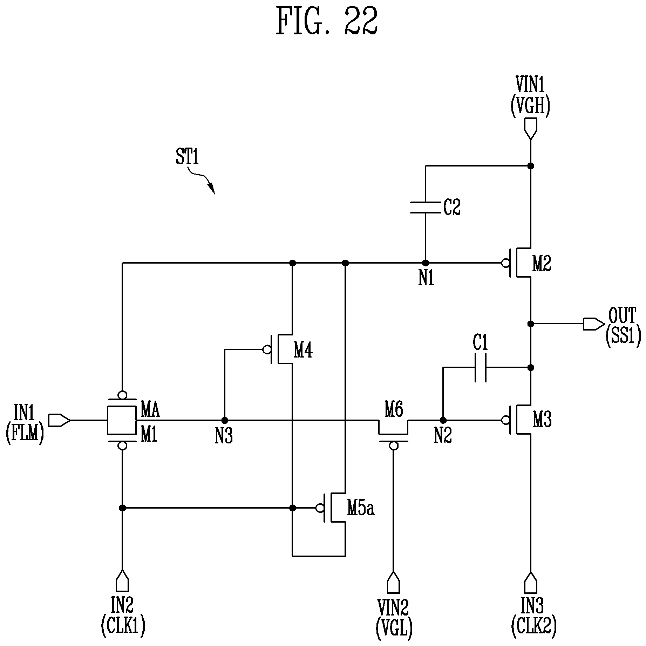

FIG. 22 is a diagram illustrating a stage circuit according to an embodiment of the present disclosure. In FIG. 22, the same reference numerals are assigned to components substantially identical to those in FIG. 19 and redundant descriptions are omitted.

Referring to FIG. 22, a stage circuit (ST1) according to an embodiment of the present disclosure includes a first transistor (M1), a second transistor (M2), a third transistor (M3), a fourth transistor (M4), a fifth transistor (M5a), a sixth transistor (M6), an auxiliary transistor (MA), a first capacitor (C1) and a second capacitor (C2).

The sixth transistor (M6) is connected between the second node (N2) and the third node (N3) and the gate electrode may be connected to the second power input terminal (VIN2). The sixth transistor (M6) may prevent the voltage of the third node (N3) from dropping below the second power source (VGL).

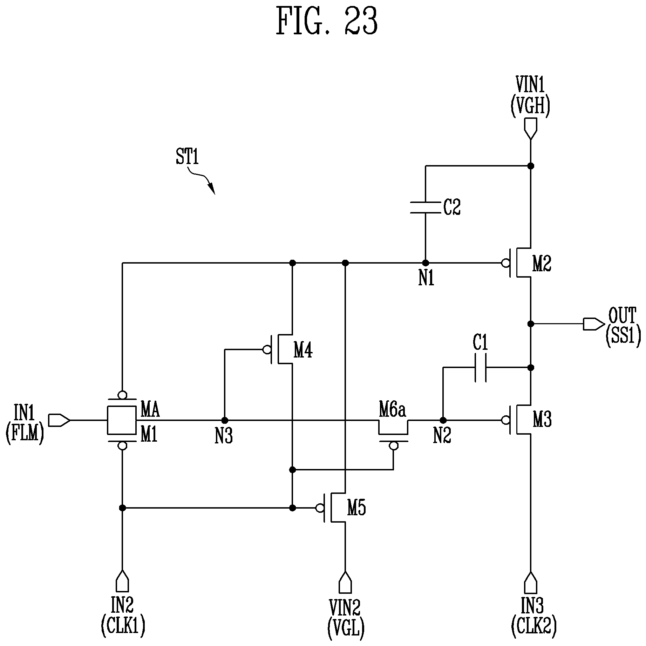

FIG. 23 is a diagram illustrating a stage circuit according to an embodiment of the present disclosure. In FIG. 23, the same reference numerals are assigned to components that are substantially the same as those in FIG. 17 and redundant descriptions are omitted.

Referring to FIG. 23, a stage circuit (ST1) according to an embodiment of the present disclosure includes a first transistor (M1), a second transistor (M2), a third transistor (M3), a fourth transistor (M4), a fifth transistor (M5), a sixth transistor (M6a), an auxiliary transistor (MA), a first capacitor (C1) and a second capacitor (C2).

The sixth transistor (M6a) may be connected between the second node (N2) and the third node (N3). In addition, the gate electrode of the sixth transistor (M6a) may be connected to the second input terminal (IN2). The sixth transistor (M6a) is turned on by the low-level first clock signal (CLK1) during the first period (P1) illustrated in FIG. 4 and accordingly, the third node (N3) and the second node (N2) may be electrically connected to one another during the first period (P1).

The sixth transistor (M6a) may be turned off by the high level first clock signal (CLK1) during the second period (P2) illustrated in FIG. 4. When the sixth transistor (M6a) is turned off, a voltage lower than the second power source (VGL) applied to the second node (N2) during the second period (P2) is not supplied to the third node (N3).

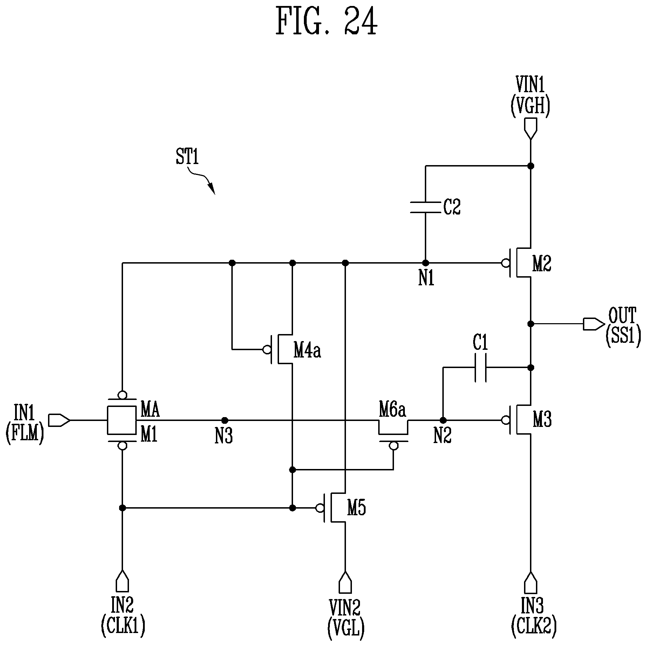

FIG. 24 is a diagram illustrating a stage circuit according to an embodiment of the present disclosure. In FIG. 24, the same reference numerals are assigned to components substantially identical to those in FIG. 18 and redundant descriptions are omitted.

Referring to FIG. 24, a stage circuit (ST1) according to an embodiment of the present disclosure includes a first transistor (M1), a second transistor (M2), a third transistor (M3), a fourth transistor (M4a), a fifth transistor (M5), a sixth transistor (M6a), an auxiliary transistor (MA), a first capacitor (C1) and a second capacitor (C2).

The sixth transistor (M6a) may be connected between the second node (N2) and the third node (N3). In addition, the gate electrode of the sixth transistor (M6a) may be connected to the second input terminal (IN2). The sixth transistor (M6a) is turned on by the low-level first clock signal (CLK1) during the first period (P1) illustrated in FIG. 4 and accordingly, the third node (N3) and the second node (N2) may be electrically connected to one another during the first period (P1).

The sixth transistor (M6a) may be turned off by the high level first clock signal (CLK1) during the second period (P2) illustrated in FIG. 4. When the sixth transistor (M6a) is turned off, a voltage lower than the second power source (VGL) applied to the second node (N2) during the second period (P2) is not supplied to the third node (N3).

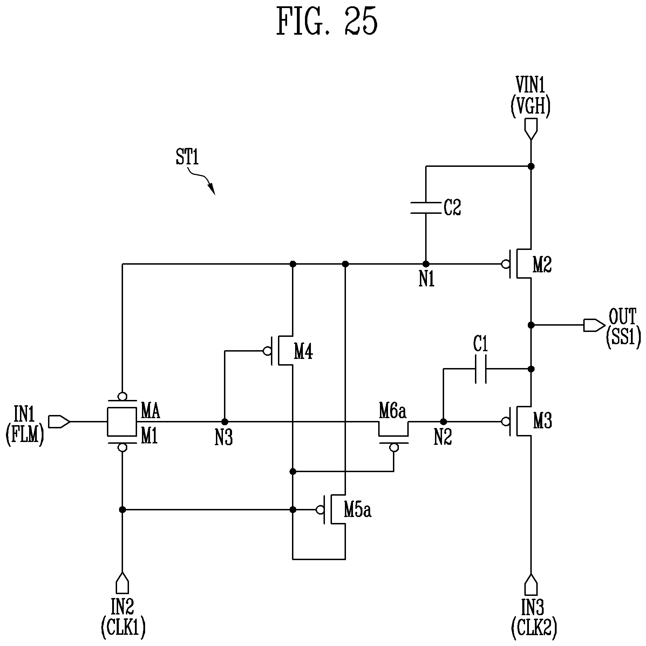

FIG. 25 is a diagram illustrating a stage circuit according to an embodiment of the present disclosure. In FIG. 25, the same reference numerals are assigned to components that are substantially the same as those in FIG. 19 and redundant descriptions are omitted.

Referring to FIG. 25, a stage circuit (ST1) according to an embodiment of the present disclosure includes a first transistor (M1), a second transistor (M2), a third transistor (M3), a fourth transistor (M4), a fifth transistor (M5a), a sixth transistor (M6a), an auxiliary transistor (MA), a first capacitor (C1) and a second capacitor (C2).

The sixth transistor (M6a) may be connected between the second node (N2) and the third node (N3). In addition, the gate electrode of the sixth transistor (M6a) may be connected to the second input terminal (IN2). The sixth transistor (M6a) is turned on by the low-level first clock signal (CLK1) during the first period (P1) illustrated in FIG. 4 and accordingly, the third node (N3) and the second node (N2) may be electrically connected to one another during the first period (P1).

The sixth transistor (M6a) may be turned off by the high level first clock signal (CLK1) during the second period (P2) illustrated in FIG. 4. When the sixth transistor (M6a) is turned off, a voltage lower than the second power source (VGL) applied to the second node (N2) during the second period (P2) is not supplied to the third node (N3).

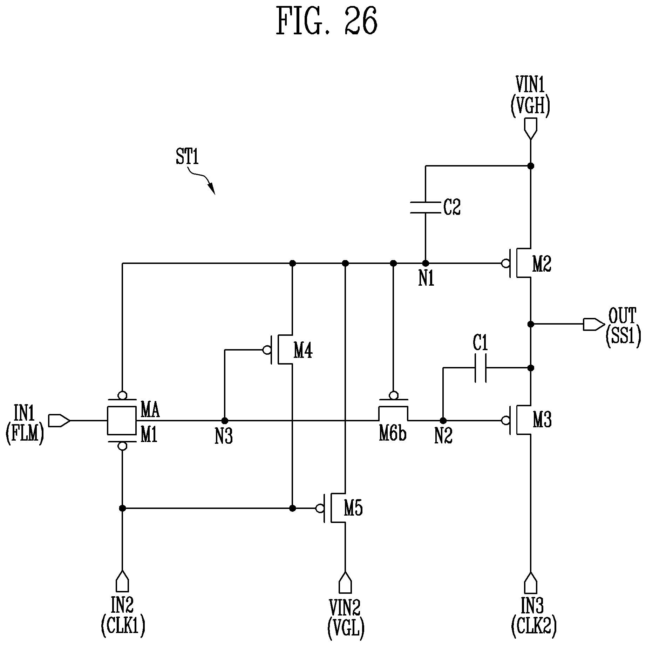

FIG. 26 is a diagram illustrating a stage circuit according to an embodiment of the present disclosure. In FIG. 26, the same reference numerals are assigned to components that are substantially the same as those in FIG. 17 and redundant descriptions are omitted.

Referring to FIG. 26, a stage circuit (ST1) according to an embodiment of the present disclosure includes a first transistor (M1), a second transistor (M2), a third transistor (M3), a fourth transistor (M4), a fifth transistor (M5), a sixth transistor (M6b), an auxiliary transistor (MA), a first capacitor (C1) and a second capacitor (C2).

The sixth transistor (M6b) may be connected between the second node (N2) and the third node (N3). In addition, the gate electrode of the sixth transistor (M6b) may be connected to the first node (N1). The sixth transistor (M6b) may control the electrical connection between the second node (N2) and the third node (N3), switching on or off depending on the voltage at the first node (N1).

The sixth transistor (M6b) is turned on by a low level voltage applied to the first node (N1) during the first period (P1) illustrated in FIG. 4 and thus the third node (N3) and the second node (N2) may be electrically connected during the first period (P1). The sixth transistor (M6b) may be turned off by a high level voltage during the second period (P2) illustrated in FIG. 4. When the sixth transistor (M6b) is turned off, a voltage lower than the second power source (VGL) applied to the second node (N2) during the second period (P2) is not supplied to the third node (N3).

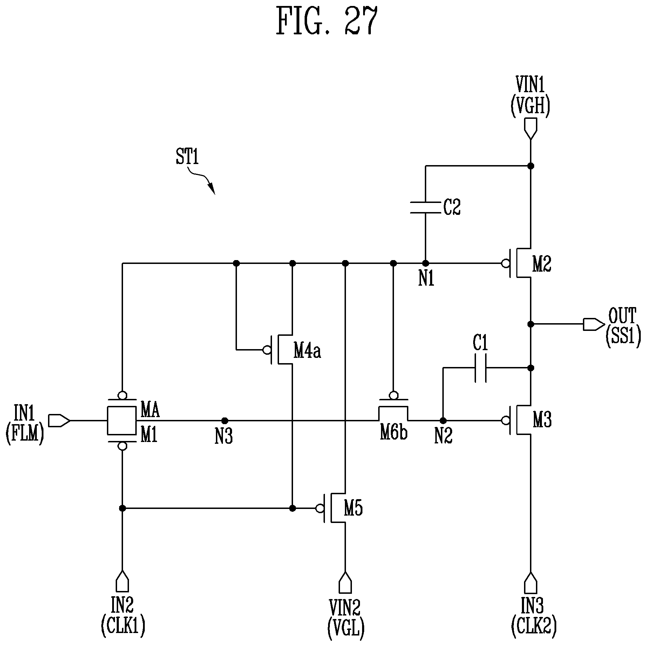

FIG. 27 is a diagram illustrating a stage circuit according to an embodiment of the present disclosure. In FIG. 27, the same reference numerals are assigned to components that are substantially the same as those in FIG. 18 and redundant descriptions are omitted.

Referring to FIG. 27, a stage circuit (ST1) according to an embodiment of the present disclosure includes a first transistor (M1), a second transistor (M2), a third transistor (M3), a fourth transistor (M4a), a fifth transistor (M5), a sixth transistor (M6b), an auxiliary transistor (MA), a first capacitor (C1) and a second capacitor (C2).

The sixth transistor (M6b) may be connected between the second node (N2) and the third node (N3). In addition, the gate electrode of the sixth transistor (M6b) may be connected to the first node (N1). The sixth transistor (M6b) may control the electrical connection between the second node (N2) and the third node (N3), switching on or off depending on the voltage at the first node (N1).

The sixth transistor (M6b) is turned on by a low level voltage applied to the first node (N1) during the first period (P1) illustrated in FIG. 4 and thus the third node (N3) and the second node (N2) may be electrically connected to one another during the first period (P1). The sixth transistor (M6b) may be turned off by a high level voltage during the second period (P2) illustrated in FIG. 4. When the sixth transistor (M6b) is turned off, a voltage lower than the second power source (VGL) applied to the second node (N2) during the second period (P2) is not supplied to the third node (N3).

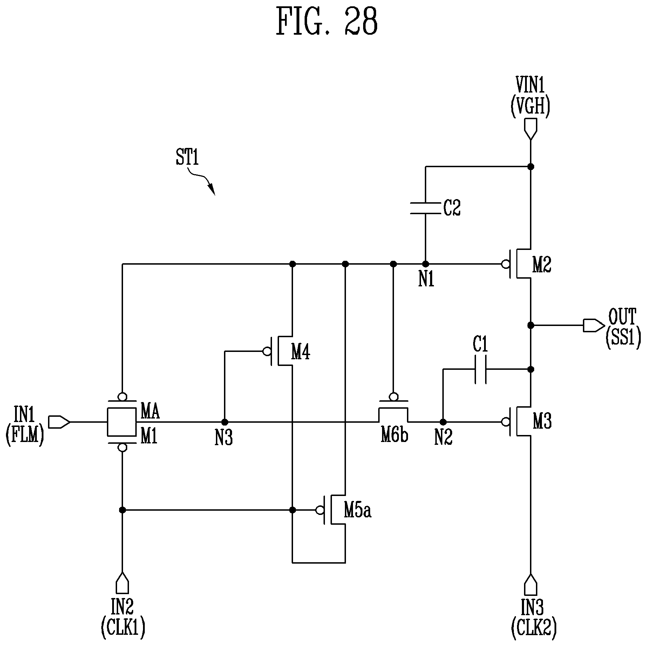

FIG. 28 is a diagram illustrating a stage circuit according to an embodiment of the present disclosure. In FIG. 28, the same reference numerals are assigned to components that are substantially the same as those in FIG. 19 and redundant descriptions are omitted.

Referring to FIG. 28, a stage circuit (ST1) according to an embodiment of the present disclosure includes a first transistor (M1), a second transistor (M2), a third transistor (M3), a fourth transistor (M4), a fifth transistor (M5a), a sixth transistor (M6b), an auxiliary transistor (MA), a first capacitor (C1) and a second capacitor (C2).

The sixth transistor (M6b) may be connected between the second node (N2) and the third node (N3). In addition, a gate electrode of the sixth transistor (M6b) may be connected to the first node (N1). The sixth transistor (M6b) may control the electrical connection between the second node (N2) and the third node (N3), switching on or off depending on the voltage at the first node (N1).

The sixth transistor (M6b) is turned on by a low level voltage applied to the first node (N1) during the first period (P1) illustrated in FIG. 4 and thus the third node (N3) and the second node (N2) may be electrically connected during the first period (P1). The sixth transistor (M6b) may be turned off by a high level voltage during the second period (P2) illustrated in FIG. 4. When the sixth transistor (M6b) is turned off, a voltage lower than the second power source (VGL) applied to the second node (N2) during the second period (P2) is not supplied to the third node (N3).

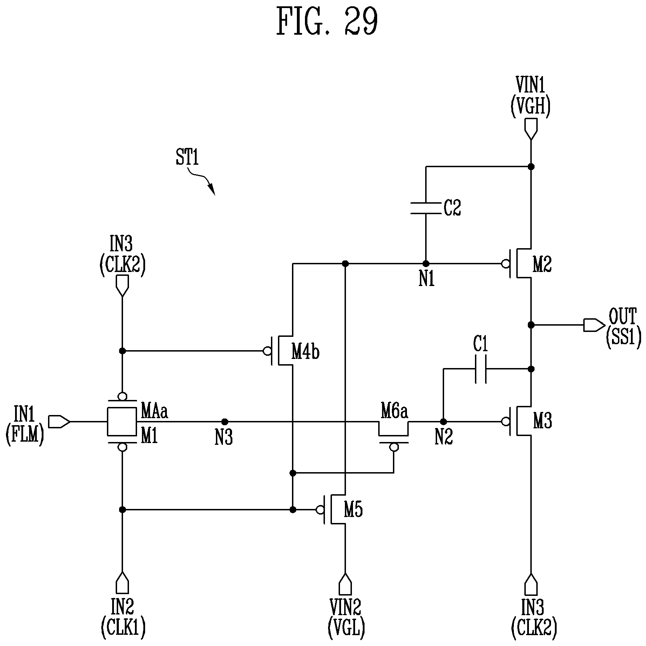

FIG. 29 is a diagram illustrating a stage circuit according to an embodiment of the present disclosure. In FIG. 29, the same reference numerals are assigned to components that are substantially the same as those in FIG. 3 and redundant descriptions are omitted.

Referring to FIG. 29, a stage circuit (ST1) according to an embodiment of the present disclosure includes a first transistor (M1), a second transistor (M2), a third transistor (M3), a fourth transistor (M4b), a fifth transistor (M5), a sixth transistor (M6a), an auxiliary transistor (MAa), a first capacitor (C1) and a second capacitor (C2).

The auxiliary transistor (MAa) may be connected between the first input terminal (IN1) and the third node (N3). For example, the auxiliary transistor (MAa) may be connected in parallel to the first transistor (M1) across the first input terminal (IN1) and the third node (N3). A gate electrode of the auxiliary transistor (MAa) may be connected to the third input terminal (IN3). The auxiliary transistor (MAa) may be turned on or off in response to the second clock signal (CLK2).

The first transistor (M1) and the auxiliary transistor (MAa), which are connected in parallel to each other, are driven by different clock signals (CLK1, CLK2). Thus, the voltage at the third node (N3) may be prevented from changing due to switching noise caused by the clock signals (CLK1, CLK2).

When the first clock signal (CLK1) has a low level, the second clock signal (CLK2) may have a high level. In addition, when the first clock signal (CLK1) has a high level, the second clock signal (CLK2) may have a low level. In this case, advantageously the switching noise due to the supply of the clock signals (CLK1, CLK2) may be canceled out. Thus the voltage of the third node (N3) may be stably maintained.

A fourth transistor (M4b) is connected between a first node (N1) and a second input terminal (IN2) and a gate electrode may be connected to a third input terminal (IN3). The fourth transistor (M4b) may be turned on or off in response to a second clock signal (CLK2) input to the third input terminal (IN3).

The fourth transistor (M4b) may be turned off during the first period (P1) illustrated in FIG. 4. At this time, the voltage of the second power source (VGL) may be supplied to the first node (N1) via the fifth transistor (M5).

The fourth transistor (M4b) may be turned on during the second period (P2) illustrated in FIG. 4. When the fourth transistor (M4b) is turned on, a high level voltage may be supplied from the second input terminal (IN2) to the first node (N1). Then, the second transistor (M2) is turned off during the second period (P2) and accordingly, the scan signal (SS1) may be stably output to the output terminal (OUT).

Thereafter, the fourth transistor (M4b) and the fifth transistor (M5) may be alternately turned on to switch between supplying a low-level voltage (e.g., the voltage of the second power source (VGL)) and a high-level voltage to the first node (N1). When the low-level voltage and the high-level voltage are alternately supplied to the first node (N1), the second transistor (M2) may alternately turn on and off to supply the voltage of the first power source (VGH) to the output terminal (OUT).

The sixth transistor (M6a) may be connected between the second node (N2) and the third node (N3). In addition, the gate electrode of the sixth transistor (M6a) may be connected to the second input terminal (IN2). The sixth transistor (M6a) may control the electrical connection between the second node (N2) and the third node (N3) by being turned on or off in response to a first clock signal (CLK1) input to the second input terminal (IN2).

The sixth transistor (M6a) is turned on by the low-level first clock signal (CLK1) during the first period (P1) illustrated in FIG. 4 and accordingly, the third node (N3) and the second node (N2) may be electrically connected to one another during the first period (P1). Then, the voltage of the low-level start signal (FLM) input to the first input terminal (IN1) during the first period (P1) may be supplied to the second node (N2) via the third node (N3).

The sixth transistor (M6a) may be turned off by the high level first clock signal (CLK1) during the second period (P2) illustrated in FIG. 4. When the sixth transistor (M6a) is turned off, the high level voltage supplied to the third node (N3) via the auxiliary transistor (MAa) during the second period (P2) is not supplied to the second node (N2). In other words, the second node (N2) may maintain a voltage lower than the second power source (VGL) during the second period (P2).

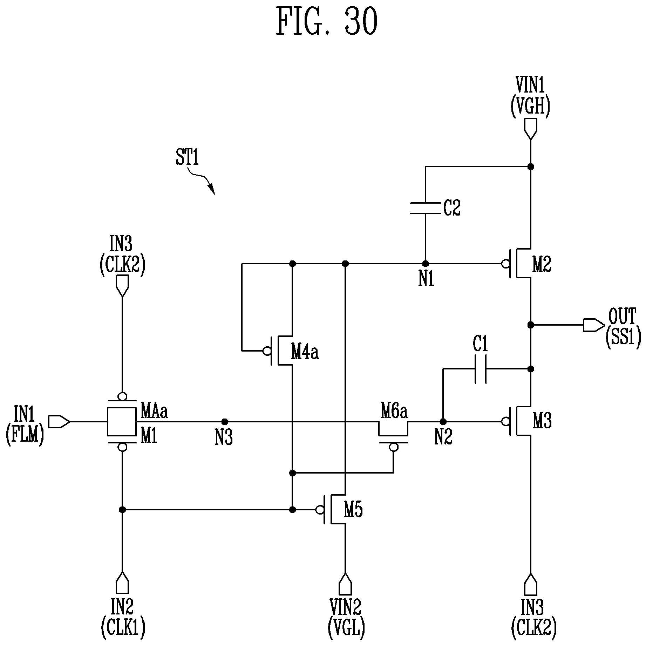

FIG. 30 is a diagram illustrating a stage circuit according to an embodiment of the present disclosure. In FIG. 30, the same reference numerals are assigned to components substantially identical to those in FIG. 7 and redundant descriptions are omitted.

Referring to FIG. 30, a stage circuit (ST1) according to an embodiment of the present disclosure includes a first transistor (M1), a second transistor (M2), a third transistor (M3), a fourth transistor (M4a), a fifth transistor (M5), a sixth transistor (M6a), an auxiliary transistor (MAa), a first capacitor (C1) and a second capacitor (C2).

The stage circuit (ST1) of FIG. 30 may have the same configuration as the stage circuit of FIG. 7 except that it additionally includes an auxiliary transistor (MAa) and a sixth transistor (M6a). Since the auxiliary transistor (MAa) and the sixth transistor (M6a) have been described with reference to FIG. 29, a detailed description thereof will be omitted.

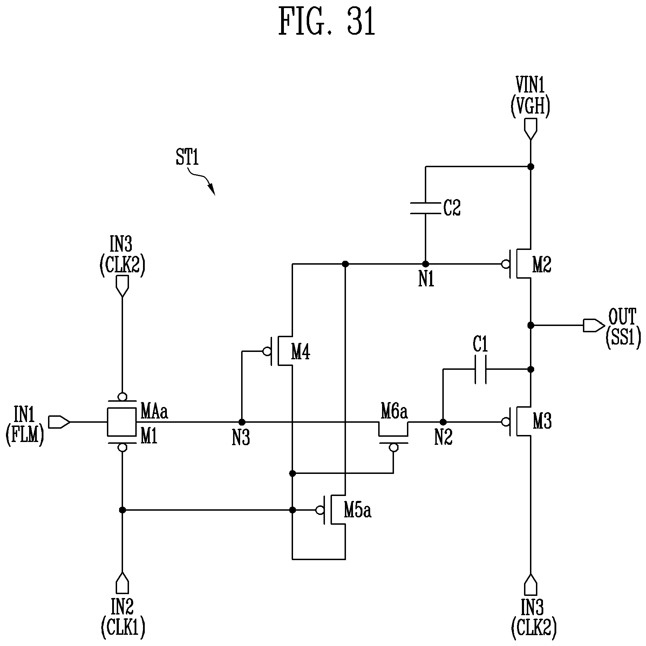

FIG. 31 is a diagram illustrating a stage circuit according to an embodiment of the present disclosure. In FIG. 31, the same reference numerals are assigned to components substantially identical to those in FIG. 6 and redundant descriptions are omitted.

Referring to FIG. 31, a stage circuit (ST1) according to an embodiment of the present disclosure includes a first transistor (M1), a second transistor (M2), a third transistor (M3), a fourth transistor (M4), a fifth transistor (M5a), a sixth transistor (M6a), an auxiliary transistor (MAa), a first capacitor (C1) and a second capacitor (C2).

The stage circuit (ST1) of FIG. 31 may have the same configuration as the stage circuit of FIG. 6 except that it additionally includes an auxiliary transistor (MAa) and a sixth transistor (M6a).

When explaining the operation process in connection with FIG. 4, the first transistor (M1) is turned on during the first period (P1) and accordingly, the second node (N2) and the third node (N3) may have low-level voltages. When the third node (N3) has the low-level voltage, the fourth transistor (M4) is turned on and accordingly, the first node (N1) may have the low-level voltage during the first period (P1).

During the first period (P1) and the second period (P2), the first clock signal (CLK1) has a high level. At this time, since the fourth transistor (M4) is maintained in a turned-on state by the voltage of the third node (N3), the first node (N1) may rise to a high level voltage.

During the second period (P2), the auxiliary transistor (MAa) is turned on by the low-level second clock signal (CLK2) and accordingly, a high-level voltage may be supplied to the third node (N3). Since the sixth transistor (M6a) is turned off by the high-level first clock signal

(CLK1) during the second period (P2), the second node (N2) may have a lower voltage than the second power source (VGL).

When a high level voltage is supplied to the third node (N3), the fourth transistor (M4) may be turned off during the second period (P2). At this time, the first node (N1) may maintain the high level voltage supplied during the period between the first period (P1) and the second period (P2). For example, the second capacitor (C2) may maintain the high level voltage supplied during the period between the first period (P1) and the second period (P2).

During the third period (P3), the first transistor (M1), the fifth transistor (M5) and the sixth transistor (M6a) may be turned on by the low level first clock signal (CLK1). When the first transistor (M1) is turned on, a high level voltage may be supplied to the third node (N3) and the second node (N2).

When the fifth transistor (M5) is turned on, the voltage of the first clock signal (CLK1) at an approximately low level is supplied to the first node (N1) and accordingly, the second transistor (M2) may be turned on. When the second transistor (M2) is turned on, the voltage of the first power source (VGH) may be supplied to the output terminal (OUT).

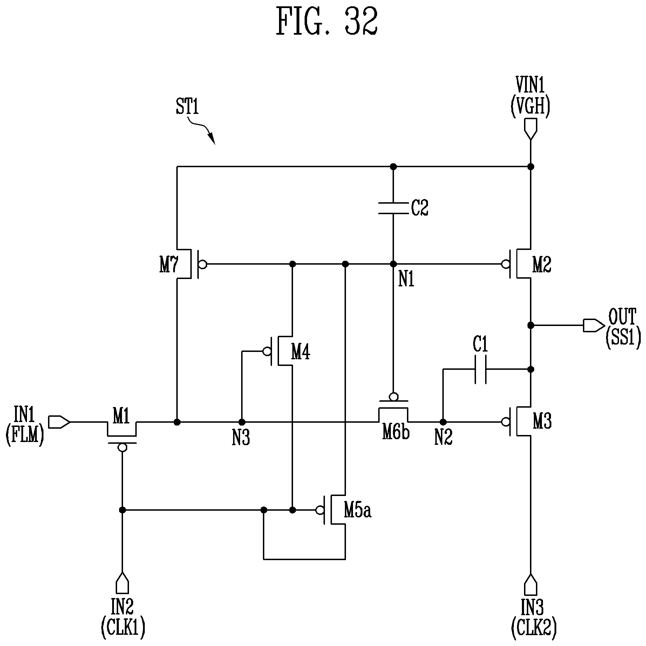

FIG. 32 is a diagram illustrating a stage circuit according to an embodiment of the present disclosure. In FIG. 32, the same reference numerals are assigned to components that are substantially the same as those in FIG. 16 and redundant descriptions are omitted.

Referring to FIG. 32, a stage circuit (ST1) according to an embodiment of the present disclosure includes a first transistor (M1), a second transistor (M2), a third transistor (M3), a fourth transistor (M4), a fifth transistor (M5a), a sixth transistor (M6b), a seventh transistor (M7), a first capacitor (C1) and a second capacitor (C2).

The seventh transistor (M7) may be connected between the first power input terminal (VIN1) and the third node (N3). In addition, a gate electrode of the seventh transistor (M7) may be connected to the first node (N1). The seventh transistor (M7) may control the electrical connection between the first power input terminal (VIN1) and the third node (N3), switching on or off depending on the voltage at the first node (N1).

The seventh transistor (M7) is turned off during the second period (P2) illustrated in FIG. 4 and thus the third node (N3) may maintain a low level voltage during the second period (P2). The seventh transistor (M7) may be turned on during the third period (P3) and a subsequent period. When the seventh transistor (M7) is turned on, the voltage of the first power source (VGH) is supplied to the third node (N3) and the second node (N2) and thus the third transistor (M3) may stably maintain a turn-off state.

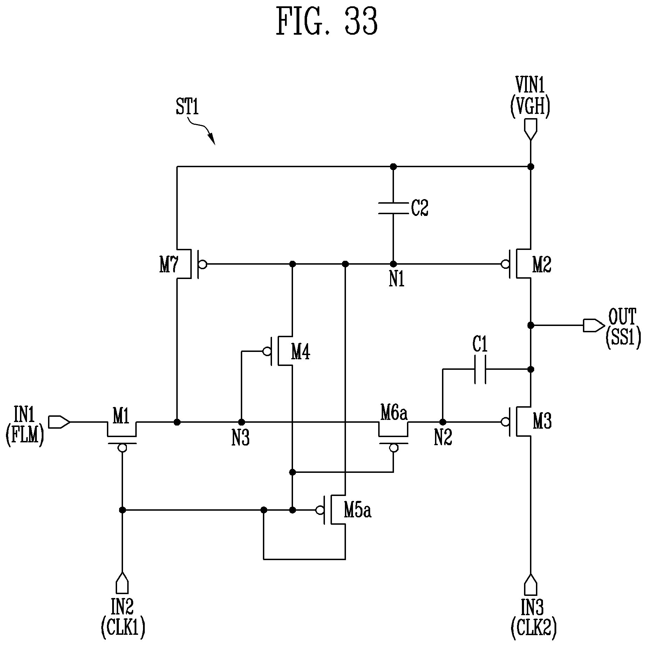

FIG. 33 is a diagram illustrating a stage circuit according to an embodiment of the present disclosure. In FIG. 33, the same reference numerals are assigned to components that are substantially the same as those in FIG. 32 and redundant descriptions are omitted.

Referring to FIG. 33, a stage circuit (ST1) according to an embodiment of the present disclosure includes a first transistor (M1), a second transistor (M2), a third transistor (M3), a fourth transistor (M4), a fifth transistor (M5a), a sixth transistor (M6a), a seventh transistor (M7), a first capacitor (C1) and a second capacitor (C2).

The sixth transistor (M6a) may be connected between the second node (N2) and the third node (N3). In addition, the gate electrode of the sixth transistor (M6a) may be connected to the second input terminal (IN2). The sixth transistor (M6a) is turned on by the low-level first clock signal (CLK1) during the first period (P1) illustrated in FIG. 4 and accordingly, the third node (N3) and the second node (N2) may be electrically connected to one another during the first period (P1).

The sixth transistor (M6a) may be turned off by the high level first clock signal (CLK1) during the second period (P2) illustrated in FIG. 4. When the sixth transistor (M6a) is turned off, a voltage lower than the second power source (VGL) applied to the second node (N2) during the second period (P2) is not supplied to the third node (N3).

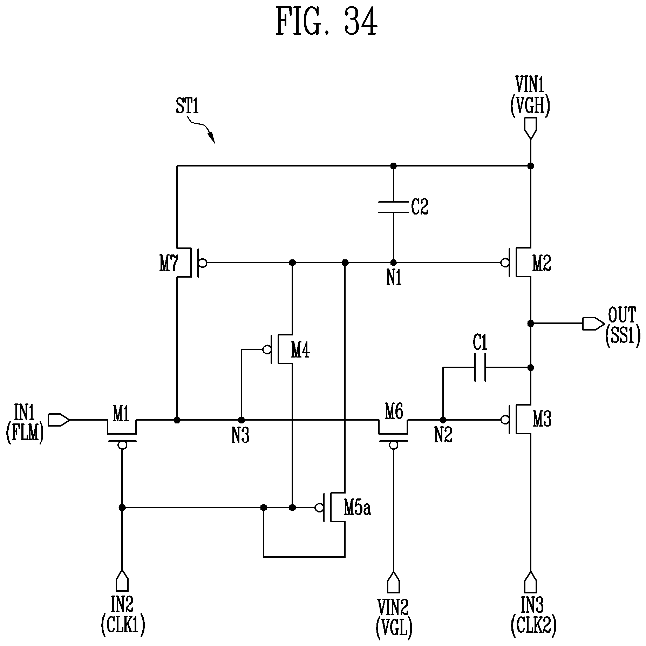

FIG. 34 is a diagram illustrating a stage circuit according to an embodiment of the present disclosure. In FIG. 34, the same reference numerals are assigned to components that are substantially the same as those in FIG. 32 and redundant descriptions are omitted.

Referring to FIG. 34, a stage circuit (ST1) according to an embodiment of the present disclosure includes a first transistor (M1), a second transistor (M2), a third transistor (M3), a fourth transistor (M4), a fifth transistor (M5a), a sixth transistor (M6), a seventh transistor (M7), a first capacitor (C1) and a second capacitor (C2).

The sixth transistor (M6) may be connected between the second node (N2) and the third node (N3). In addition, the gate electrode of the sixth transistor (M6) may be connected to the second power input terminal (VIN2). The sixth transistor (M6) may electrically connect the second node (N2) and the third node (N3) while maintaining a turned-on state due to the second power source (VGL) input to the second power input terminal (VIN2).

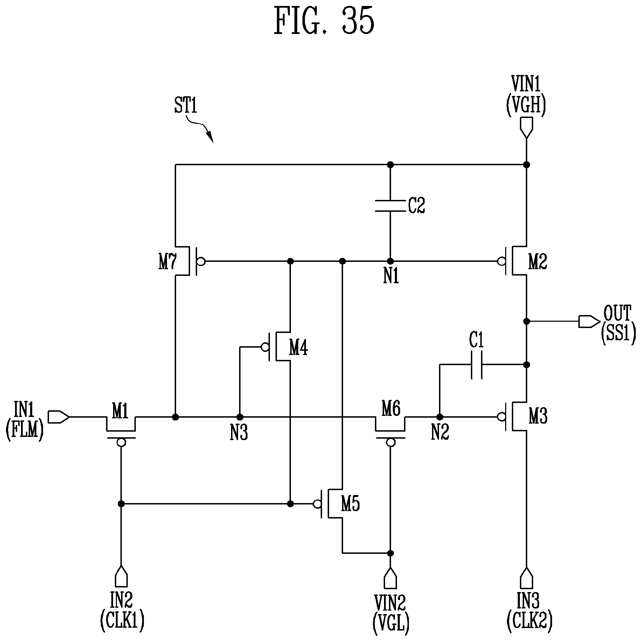

FIG. 35 is a diagram illustrating a stage circuit according to an embodiment of the present disclosure. In FIG. 35, the same reference numerals are assigned to components substantially identical to those in FIG. 8 and redundant descriptions are omitted.

Referring to FIG. 35, a stage circuit (ST1) according to an embodiment of the present disclosure includes a first transistor (M1), a second transistor (M2), a third transistor (M3), a fourth transistor (M4), a fifth transistor (M5), a sixth transistor (M6), a seventh transistor (M7), a first capacitor (C1) and a second capacitor (C2).

The seventh transistor (M7) may be connected between the first power input terminal (VIN1) and the third node (N3). In addition, the gate electrode of the seventh transistor (M7) may be connected to the first node (N1). The seventh transistor (M7) may control the electrical connection between the first power input terminal (VIN1) and the third node (N3), switching on or off depending on the voltage at the first node (N1).

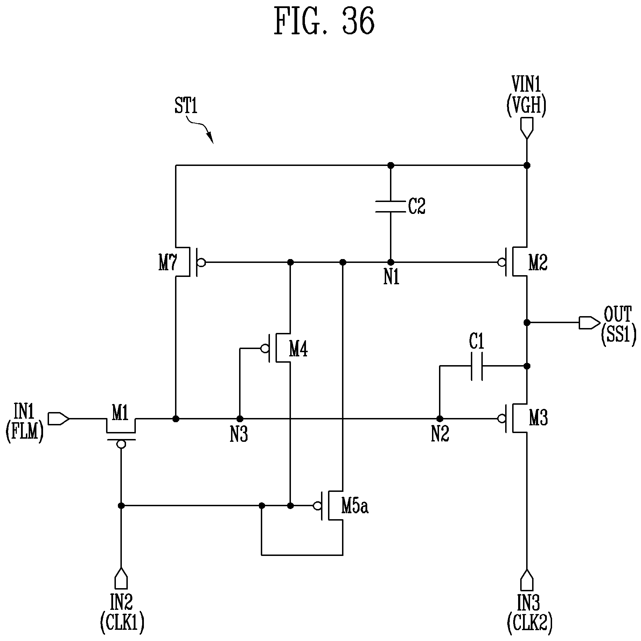

FIG. 36 is a diagram illustrating a stage circuit according to an embodiment of the present disclosure. In FIG. 36, the same reference numerals are assigned to components that are substantially the same as those in FIG. 6 and redundant descriptions are omitted.

Referring to FIG. 36, a stage circuit (ST1) according to an embodiment of the present disclosure includes a first transistor (M1), a second transistor (M2), a third transistor (M3), a fourth transistor (M4), a fifth transistor (M5a), a seventh transistor (M7), a first capacitor (C1) and a second capacitor (C2).

The stage circuit (ST1) of FIG. 36 includes the addition of the seventh transistor (M7) compared to the configuration in FIG. 6. Since the seventh transistor (M7) has been described with reference to FIG. 32, a detailed description thereof will be omitted.

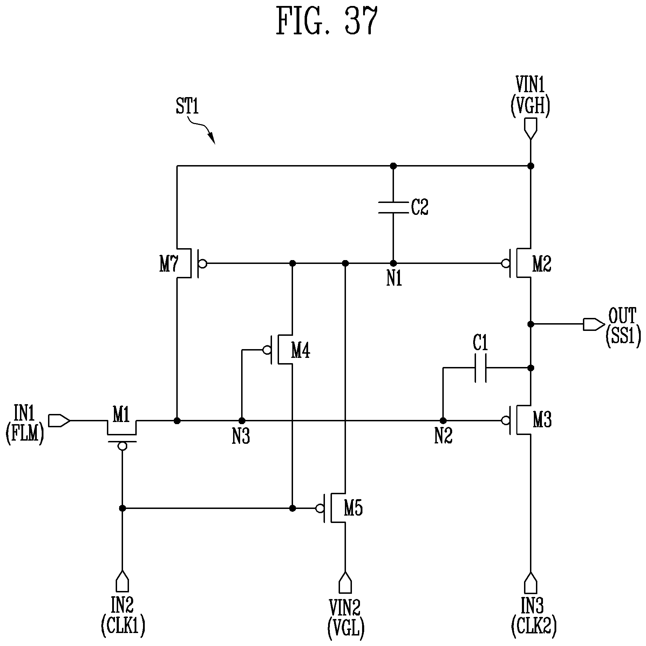

FIG. 37 is a diagram illustrating a stage circuit according to an embodiment of the present disclosure. In FIG. 37, the same reference numerals are assigned to components that are substantially the same as those in FIG. 3 and redundant descriptions are omitted.

Referring to FIG. 37, a stage circuit (ST1) according to an embodiment of the present disclosure includes a first transistor (M1), a second transistor (M2), a third transistor (M3), a fourth transistor (M4), a fifth transistor (M5), a seventh transistor (M7), a first capacitor (C1) and a second capacitor (C2).

The stage circuit (ST1) of FIG. 37 includes the addition of the seventh transistor (M7) compared to the configuration in FIG. 3. Since the seventh transistor (M7) has been described with reference to FIG. 32, a detailed description thereof will be omitted.

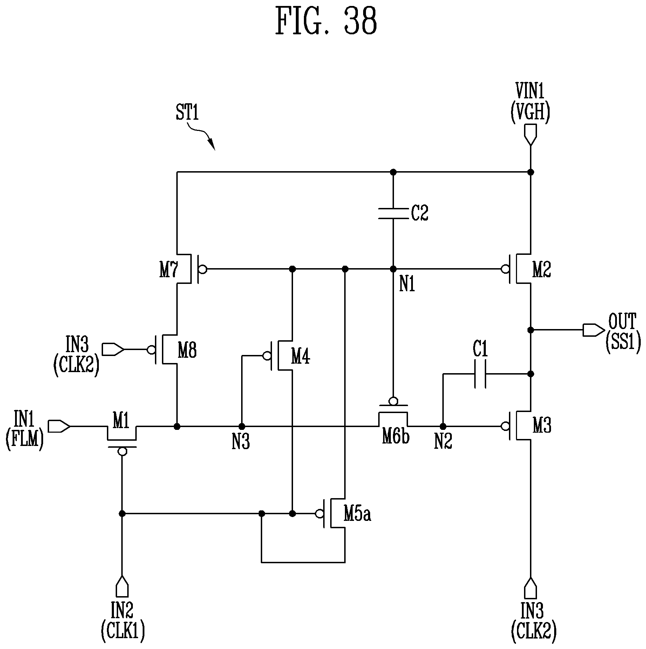

FIG. 38 is a diagram illustrating a stage circuit according to an embodiment of the present disclosure. In FIG. 38, the same reference numerals are assigned to components that are substantially the same as those in FIG. 32 and redundant descriptions are omitted.

Referring to FIG. 38, a stage circuit (ST1) according to an embodiment of the present disclosure includes a first transistor (M1), a second transistor (M2), a third transistor (M3), a fourth transistor (M4), a fifth transistor (M5a), a sixth transistor (M6b), a seventh transistor (M7), an eighth transistor (M8), a first capacitor (C1) and a second capacitor (C2).

The eighth transistor (M8) may be connected between the seventh transistor (M7) and the third node (N3). In addition, the gate electrode of the eighth transistor (M8) may be connected to the third input terminal (IN3). The eighth transistor (M8) may be turned on or off in response to the second clock signal (CLK2) input to the third input terminal (IN3).

The eighth transistor (M8) may be turned on when a low-level second clock signal (CLK2) is input during the period in which the seventh transistor (M7) is turned on, thereby supplying the voltage of the first power source (VGH) to the third node (N3). However, if the eighth transistor (M8) is present, the switching noise of the eighth transistor (M8) due to the second clock signal (CLK2) may be supplied to the third node (N3). In addition, if the eighth transistor (M8) is present, power consumption may increase due to the second clock signal (CLK2).

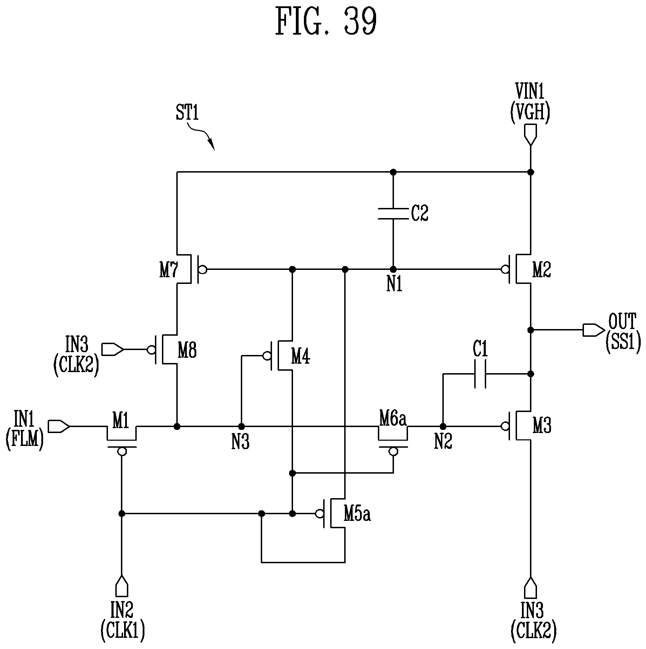

FIG. 39 is a diagram illustrating a stage circuit according to an embodiment of the present disclosure. In FIG. 39, the same reference numerals are assigned to components that are substantially the same as those in FIG. 33 and redundant descriptions are omitted.

Referring to FIG. 39, a stage circuit (ST1) according to an embodiment of the present disclosure includes a first transistor (M1), a second transistor (M2), a third transistor (M3), a fourth transistor (M4), a fifth transistor (M5a), a sixth transistor (M6a), a seventh transistor (M7), an eighth transistor (M8), a first capacitor (C1) and a second capacitor (C2).

The stage circuit (ST1) of FIG. 39 include an additional eighth transistor (M8) compared to the configuration in FIG. 33. Since the eighth transistor (M8) has been described with reference to FIG. 38, a detailed description thereof will be omitted.

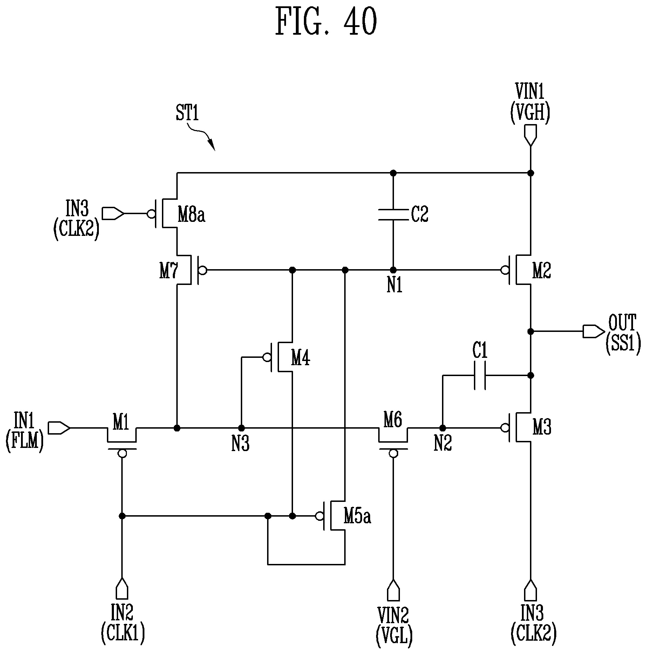

FIG. 40 is a diagram illustrating a stage circuit according to an embodiment of the present disclosure. In FIG. 40, the same reference numerals are assigned to components that are substantially the same as those in FIG. 34 and redundant descriptions are omitted.

Referring to FIG. 40, a stage circuit (ST1) according to an embodiment of the present disclosure includes a first transistor (M1), a second transistor (M2), a third transistor (M3), a fourth transistor (M4), a fifth transistor (M5a), a sixth transistor (M6), a seventh transistor (M7), an eighth transistor (M8a), a first capacitor (C1) and a second capacitor (C2).

The eighth transistor (M8a) may be connected between the seventh transistor (M7) and the first power input terminal (VIN1). In addition, the gate electrode of the eighth transistor (M8a) may be connected to the third input terminal (IN3). The eighth transistor (M8a) may be turned on or off in response to the second clock signal (CLK2) input to the third input terminal (IN3).

The eighth transistor (M8a) may be turned on when a low-level second clock signal (CLK2) is input during the period in which the seventh transistor (M7) is turned on, thereby supplying the voltage of the first power source (VGH) to the third node (N3).

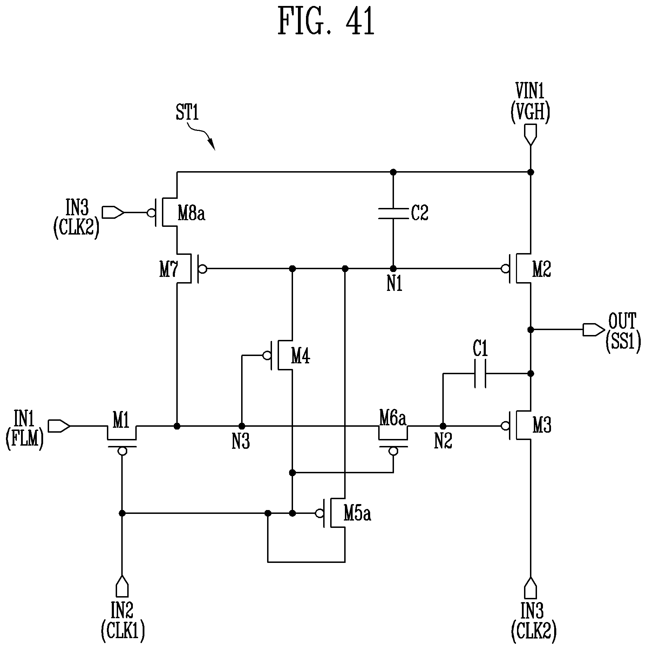

FIG. 41 is a diagram illustrating a stage circuit according to an embodiment of the present disclosure. In FIG. 41, the same reference numerals are assigned to components that are substantially the same as those in FIG. 33 and redundant descriptions are omitted.

Referring to FIG. 41, a stage circuit (ST1) according to an embodiment of the present disclosure includes a first transistor (M1), a second transistor (M2), a third transistor (M3), a fourth transistor (M4), a fifth transistor (M5a), a sixth transistor (M6a), a seventh transistor (M7), an eighth transistor (M8a), a first capacitor (C1) and a second capacitor (C2).

The stage circuit (ST1) of FIG. 41 includes the addition of the eighth transistor (M8a) compared to the configuration in FIG. 33. Since the eighth transistor (M8a) has been described with reference to FIG. 40, a detailed description thereof will be omitted.

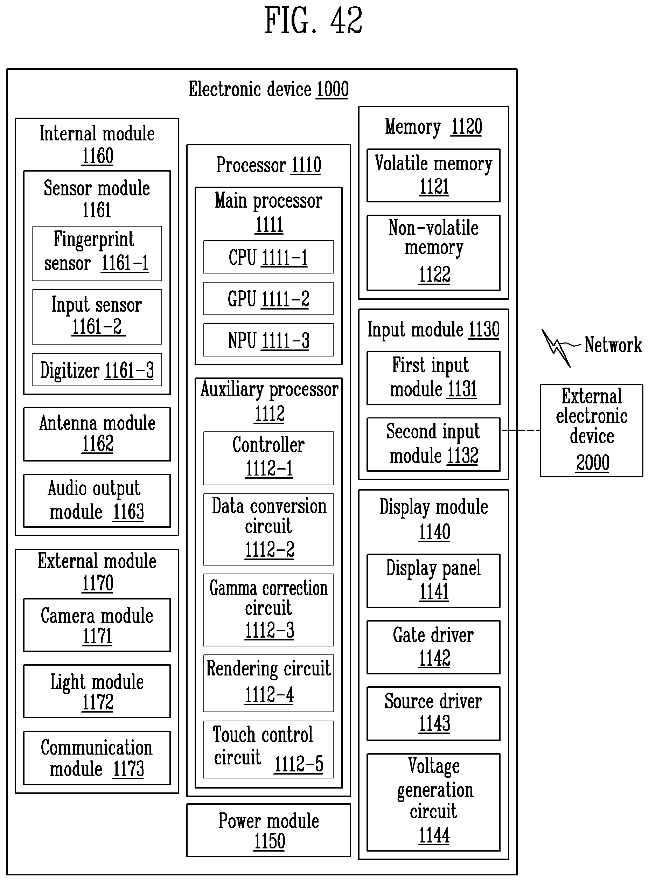

FIG. 42 is a diagram illustrating an electronic device according to an embodiment of the present disclosure.

Referring to FIG. 42, an electronic device 1000 according to an embodiment of the present disclosure outputs various information through a display module 1140 of the electronic device 1000. When a processor 1110 of the electronic device 1000 executes an application stored in a memory 1120 of the electronic device 1000, the display module 1140 provides application information to a user through a display panel 1141 of the electronic device 1000.

The processor 1110 obtains external input through an input module 1130 of the electronic device 1000 or a sensor module 1161 of the electronic device 1000 and executes an application corresponding to the external input. For example, when the user selects a camera icon (or a camera application icon) displayed on the display panel 1141, the processor 1110 obtains the user's input through an input sensor 1161-2 of a sensor module 1161 of an internal module 1160 of the electronic device 1000 and activates a camera module 1171 of an external module 1170 of the electronic device 1000. The processor 1110 transfers image data corresponding to the captured image obtained through the camera module 1171 to the display module 1140. The display module 1140 may display an image corresponding to the captured image through the display panel 1141.

As another example, when personal information authentication is executed in the display module 1140, a fingerprint sensor 1161-1 of the sensor module 1161 acquires the input fingerprint information as input data. The processor 1110 compares the input data acquired through the fingerprint sensor 1161-1 with the authentication data stored in a memory 1120 of the electronic device 1000 and executes the application according to the comparison result. The display module 1140 may display the information executed according to the logic of the application through the display panel 1141. The fingerprint sensor 1161-1 may be arranged so as to acquire fingerprint information in the entire area of the display module 1140 (or the display panel 1141).

As another example, when a music streaming icon displayed on the display module 1140 is selected, the processor 1110 obtains user input through the input sensor 1161-2 and activates a music streaming application stored in the memory 1120. When a music execution command is input from the music streaming application, the processor 1110 activates an audio output module 1163 of the electronic device 100 to provide the user with audio information corresponding to the music execution command.

Above, the operation of the electronic device 1000 has been briefly described. Below, the configuration of the electronic device 1000 will be described in detail. Some of the configurations of the electronic device 1000 described below may be integrated and provided as one configuration and one configuration may be provided by being separated into two or more configurations.

The electronic device 1000 may communicate with an external electronic device 2000 via a network (e.g., a short-range wireless communication network or a long-range wireless communication network). According to an embodiment, the electronic device 1000 may include a processor 1110, a memory 1120, an input module 1130, a display module 1140, a power module 1150, an internal module 1160 and an external module 1170. According to an embodiment, at least one of the above-described components may be omitted from the electronic device 1000 or one or more other components may be added to the electronic device 1000. According to an embodiment, some of the above-described components (e.g., the sensor module 1161, the antenna module 1162 or the audio output module 1163) may be integrated into another component (e.g., the display module 1140).

The processor 1110 may execute software to control at least one other component (e.g., a hardware or software component) of the electronic device 1000 connected to the processor 1110 and perform various data processing or calculations. According to an embodiment, as at least a part of the data processing or calculations, the processor 1110 may store a command or data received from another component (e.g., an input module 1130, a sensor module 1161 or a communication module 1173) in a volatile memory 1121, process the command or data stored in the volatile memory 1121 and store result data in a nonvolatile memory 1122.

The processor 1110 may include a main processor 1111 and an auxiliary processor 1112. The main processor 1111 may include a central processing unit (CPU: central processing unit) 1111-1. The main processor 1111 may further include one or more of a graphic processing unit (GPU: graphic processing unit) 1111-2, a communication processor (CP: communication processor) and an image signal processor (ISP: image signal processor). The main processor 1111 may further include a neural processing unit (NPU: neural processing unit) 1111-3. The neural processing unit 1111-3 is a processor specialized in processing an artificial intelligence model and the artificial intelligence model may be generated through machine learning. The artificial intelligence model may include a plurality of artificial neural network layers. The artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-networks or a combination of two or more of the above, but is not limited to the examples described above. In addition to the hardware structure, the artificial intelligence model may additionally or alternatively include a software structure. At least two of the processing units and processors described above may be implemented as a single integrated configuration (e.g., a single chip) or each may be implemented as an independent configuration (e.g., multiple chips).

The auxiliary processor 1112 may include a controller 1112-1. The controller 1112-1 may include an interface conversion circuit and a timing control circuit. For example, the auxiliary processor 1112 may include a timing controller 140 illustrated in FIG. 1. At least some functions (or configurations) of the timing controller 140 may be included in the controller 1112-1, the data conversion circuit 1112-2, the gamma correction circuit 1112-3, the rendering circuit 1112-4, etc.

The controller 1112-1 receives a video signal from the main processor 1111, converts the data format of the video signal to match the interface specifications with the display module 1140 and outputs the video data. The controller 1112-1 may output various control signals necessary for driving the display module 1140.

The auxiliary processor 1112 may further include a data conversion circuit 1112-2, a gamma correction circuit 1112-3, a rendering circuit 1112-4, a touch control circuit 1112-5, etc. The data conversion circuit 1112-2 may receive image data from the controller 1112-1 and may compensate for the image data so that the image is displayed at a desired brightness according to the characteristics of the electronic device 1000 or the user's settings or may convert the image data to reduce power consumption or compensate for afterimages.

The gamma correction circuit 1112-3 may convert image data or a gamma reference voltage so that the image displayed on the electronic device 1000 has the desired gamma characteristics. The rendering circuit 1112-4 may receive image data from the controller 1112-1 and render the image data by taking into consideration the pixel layout of the display panel 1141 applied to the electronic device 1000.

The touch control circuit 1112-5 may supply a touch signal to the input sensor 1161-2 and receive a sensing signal from the input sensor 1161-2 in response to the touch signal.

At least one of the data conversion circuit 1112-2, the gamma correction circuit 1112-3, the rendering circuit 1112-4 and the touch control circuit 1112-5 may be integrated into another component (e.g., the main processor 1111 or the controller 1112-1). At least one of the data conversion circuit 1112-2, the gamma correction circuit 1112-3 and the rendering circuit 1112-4 may also be integrated into the source driver 1143 described below.

The memory 1120 may store various data used by at least one component (e.g., a processor 1110 or a sensor module 1161) of the electronic device 1000 and input data or output data for commands related thereto. In addition, various setting data corresponding to the user's settings may be stored in the memory 1120. The memory 1120 may include at least one of a volatile memory 1121 and a nonvolatile memory 1122.

The input module 1130 may receive commands or data to be used for components of the electronic device 1000 (e.g., a processor 1110, a sensor module 1161 or an audio output module 1163) from an external source of the electronic device 1000 (e.g., the user or an external electronic device 2000).

The input module 1130 may include a first input module 1131 into which a command or data is input from the user and a second input module 1132 into which a command or data is input from an external electronic device 2000. The first input module 1131 may include a microphone, a mouse, a keyboard, a key (e.g., a button) or a pen (e.g., a passive pen or an active pen). The second input module 1132 may support a designated protocol that may be connected to the external electronic device 2000 by wire or wirelessly. According to an embodiment, the second input module 1132 may include a high definition multimedia interface (HDMI), a universal serial bus (USB) interface, an SD card interface or an audio interface. The second input module 1132 may include a connector that may be physically connected to the external electronic device 2000, for example, an HDMI connector, a USB connector, an SD card connector or an audio connector (e.g., a headphone connector).

The display module 1140 provides information visually to the user. The display module 1140 may include a display panel 1141, a gate driver 1142, a source driver 1143 and a voltage generation circuit 1144. The display module 1140 may further include a window, a chassis and a bracket for protecting the display panel 1141. Such a display module 1140 may include at least a part of the configuration of the display device 100 illustrated in FIG. 1.

The display panel 1141 (or display) may include a liquid crystal display panel, an organic light-emitting display panel or an inorganic light-emitting display panel and the type of the display panel 1141 is not particularly limited. The display panel 1141 may be a rigid type or a flexible type that can be rolled or folded. The display module 1140 may further include a supporter, a bracket, a heat dissipation member or the like that supports the display panel 1141. The display panel 1141 may include the display 110 illustrated in FIG. 1.

The gate driver 1142 may be mounted on the display panel 1141 as a driving chip. In addition, the gate driver 1142 may be integrated into the display panel 1141. For example, the gate driver 1142 may include an ASG (Amorphous Silicon TFT Gate driver circuit), an LTPS (Low Temperature Polycrystalline Silicon) TFT Gate driver circuit or an OSG (Oxide Semiconductor TFT Gate driver circuit) internalized in the display panel 1141. The gate driver 1142 receives a control signal from the controller 1112-1 and outputs scan signals to the display panel 1141 in response to the control signal. The gate driver 1142 may include or be the scan driver 130 illustrated in FIG. 1. For example, the gate driver 1142 may include at least one of the stage circuits illustrated in FIGS. 2 to 41.

The display module 1140 may further include a light-emitting driver. The light-emitting driver outputs a light-emitting control signal to the display panel 1141 in response to a control signal received from the controller 1112-1. The light-emitting driver may be formed separately from the gate driver 1142 or may be integrated into the gate driver 1142.

The source driver 1143 receives a control signal from the controller 1112-1, converts image data into an analog voltage (e.g., a data signal) in response to the control signal and then outputs data signals to the display panel 1141. The source driver 1143 may include the data driver 120 illustrated in FIG. 1.

The source driver 1143 may be integrated into another component (e.g., the controller 1112-1). The functions of the interface conversion circuit and the timing control circuit of the above-described controller 1112-1 may also be integrated into the source driver 1143. The voltage generation circuit 1144 may output various voltages required for driving the display panel 1141. The voltage generation circuit 1144 may include the power supply 150 illustrated in FIG. 1.

In an embodiment, the source driver 1143 may convert data corresponding to red (R), green (G) and blue (B) included in image data received from the processor 1110 into a red data signal (or data voltage), a green data signal and a blue data signal and provide the data to a plurality of pixel columns included in the display panel 1141 during one horizontal period.

The power module 1150 supplies power to components of the electronic device 1000. The power module 1150 may include a battery that charges a power voltage. The battery may include a non-rechargeable primary battery, a rechargeable secondary battery or a fuel cell. The power module 1150 may include a power management integrated circuit (PMIC). The PMIC supplies power optimized for each of the modules described above and the modules described below. The power module 1150 may include a wireless power transmitting/receiving member electrically connected to the battery. The wireless power transmitting/receiving member may include a plurality of coil-shaped antenna radiators. In an embodiment, at least a portion of the configuration of the power module 1150 and the voltage generation circuit 1144 may be provided as one integrated unit. For example, the voltage generation circuit 1144 may be included in the power module 1150.

The electronic device 1000 may further include an internal module 1160 and an external module 1170. The internal module 1160 may include a sensor module 1161, an antenna module 1162 and an audio output module 1163. The external module 1170 may include a camera module 1171, a light module 1172 and a communication module 1173.

The sensor module 1161 may detect an input by the user's body or an input by a pen among the first input modules 1131, In addition, generate an electric signal or data value corresponding to the input. The sensor module 1161 may include at least one of a fingerprint sensor 1161-1, an input sensor 1161-2 and a digitizer 1161-3.

The fingerprint sensor 1161-1 may generate a data value corresponding to the user's fingerprint.

The input sensor 1161-2 may generate data values corresponding to coordinate information of input by the user's body or input by the pen. The input sensor 1161-2 generates a change in electrostatic capacitance due to the input as a data value. The input sensor 1161-2 may detect input by a passive pen or transmit and receive data with an active pen.

The input sensor 1161-2 may also measure bio-signals such as blood pressure, moisture, or body fat. For example, when the user touches a part of his or her body to the sensor layer or sensing panel and does not move for a certain period of time, the input sensor 1161-2 may detect a bio-signal based on a change in the electric field caused by the part of his or her body and output the information desired by the user to the display module 1140.

The digitizer 1161-3 may generate data values corresponding to coordinate information of input by the pen. The digitizer 1161-3 generates an electromagnetic change amount due to the input as a data value. The digitizer 1161-3 may detect input by a passive pen or transmit and receive data with an active pen.

At least one of the fingerprint sensor 1161-1, the input sensor 1161-2 and the digitizer 1161-3 may be implemented as a sensor layer formed on the display panel 1141 through a continuous process. At least one of the fingerprint sensor 1161-1, the input sensor 1161-2 and the digitizer 1161-3 may be disposed on an upper side of the display panel 1141 and one of the fingerprint sensor 1161-1, the input sensor 1161-2 and the digitizer 1161-3, for example, the digitizer 1161-3, may be disposed on a lower side of the display panel 1141.

At least two of the fingerprint sensor 1161-1, the input sensor 1161-2 and the digitizer 1161-3 may be formed to be integrated into one sensing panel through the same process. When integrated into one sensing panel, the sensing panel may be arranged between the display panel 1141 and a window arranged on an upper side of the display panel 1141. According to an embodiment, the sensing panel may be arranged on the window and the position of the sensing panel is not particularly limited.

At least one of the fingerprint sensor 1161-1, the input sensor 1161-2 and the digitizer 1161-3 may be embedded into the display panel 1141. In other words, at least one of the fingerprint sensor 1161-1, the input sensor 1161-2, and the digitizer 1161-3 may be formed simultaneously through a process of forming elements (e.g., light-emitting elements, transistors, etc.) included in the display panel 1141.

In addition, the sensor module 1161 may generate an electric signal or data value corresponding to an internal state or external state of the electronic device 1000. The sensor module 1161 may further include, for example, a gesture sensor, a gyro sensor, a pressure sensor, a magnetic sensor, an acceleration sensor, a grip sensor, a proximity sensor, a color sensor, an IR (infrared) sensor, a biometric sensor, a temperature sensor, a humidity sensor or an illuminance sensor.

The antenna module 1162 may include one or more antennas for transmitting or receiving signals or power to or from the outside. According to an embodiment, the communication module 1173 may transmit or receive signals to or from an external electronic device through an antenna suitable for a communication method. The antenna pattern of the antenna module 1162 may be integrated into one component of the display module 1140 (e.g., the display panel 1141 or the input sensor 1161-2.

The audio output module 1163 is a device for outputting an audio signal to the outside of the electronic device 1000 and may include, for example, a speaker used for general purposes such as multimedia playback or recording playback and a receiver used exclusively for phone reception. According to an embodiment, the receiver may be formed integrally with or separately from the speaker. The audio output pattern of the audio output module 1163 may also be integrated into the display module 1140.

The camera module 1171 may capture still images and moving images. According to an embodiment, the camera module 1171 may include one or more lenses, image sensors or image signal processors. The camera module 1171 may further include an infrared camera that can measure the presence or absence of a user, the location of the user, the line of sight of the user, etc.

The light module 1172 may provide light. The light module 1172 may include a light emitting diode or a xenon lamp. The light module 1172 may operate in conjunction with the camera module 1171 or may operate independently.

The communication module 1173 may support the establishment of a wired or wireless communication channel between the electronic device 1000 and the external electronic device 2000 and the performance of communication through the established communication channel. The communication module 1173 may include any one or all of a wireless communication module such as a cellular communication module, a short-range wireless communication module or a GNSS (global navigation satellite system) communication module and a wired communication module such as a LAN (local area network) communication module or a power line communication module. The communication module 1173 may communicate with the external electronic device 2000 through a short-range communication network such as Bluetooth, WiFi direct or IrDA (infrared data association) or a long-range communication network such as a cellular network, the Internet or a computer network (e.g., a LAN or WAN). The various types of communication modules 1173 described above may be implemented as one chip or may be implemented as separate chips.

The input module 1130, the sensor module 1161, the camera module 1171, and the like, may be used to control the operation of the display module 1140 in conjunction with the processor 1110.

The processor 1110 outputs a command or data to the display module 1140, the audio output module 1163, the camera module 1171 or the light module 1172 based on the input data received from the input module 1130. For example, the processor 1110 may generate image data corresponding to input data applied through a mouse or an active pen and output the image data to the display module 1140 or generate command data corresponding to the input data and output the image data to the camera module 1171 or the light module 1172. When input data is not received from the input module 1130, the processor 1110 may switch the operation mode of the electronic device 1000 to a low-power mode or a sleep mode to reduce power consumption of the electronic device 1000.

The processor 1110 outputs a command or data to the display module 1140, the audio output module 1163, the camera module 1171 or the light module 1172 based on the sensing data received from the sensor module 1161. For example, the processor 1110 may compare the authentication data authorized by the fingerprint sensor 1161-1 with the authentication data stored in the memory 1120 and then execute an application based on the comparison result. The processor 1110 may execute a command or output corresponding image data to the display module 1140 based on the sensing data detected by the input sensor 1161-2 or the digitizer 1161-3. When the sensor module 1161 includes a temperature sensor, the processor 1110 may receive temperature data on the temperature measured from the sensor module 1161 and further perform brightness correction or the like on the image data based on the temperature data.

The processor 1110 may receive measurement data on the presence or absence of a user, the user's location, the user's line of sight, etc. from the camera module 1171. The processor 1110 may further perform brightness correction or the like on the image data based on the measurement data. For example, the processor 1110 that determines the presence or absence of a user through input from the camera module 1171 may output the image data whose brightness has been corrected through the data conversion circuit 1112-2 or the gamma correction circuit 1112-3 to the display module 1140.

Some of the above components may be connected to each other through a communication method between peripheral devices, such as a bus, a GPIO (general purpose input/output), a SPI (serial peripheral interface), a MIPI (mobile industry processor interface) or a UPI (ultra path interconnect) link and may exchange signals (e.g., commands or data) with each other. The processor 1110 may communicate with the display module 1140 through a mutually agreed upon interface and may use, for example, any one of the above-described communication methods and is not limited to the above-described communication methods.

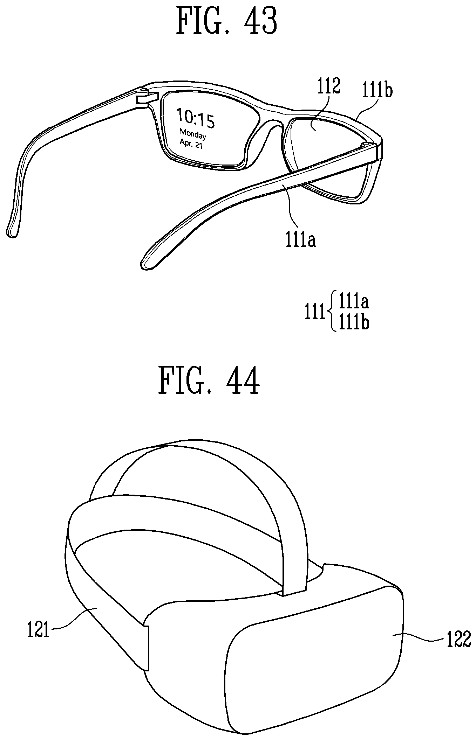

FIGS. 43 to 46 are exemplary diagrams illustrating electronic devices according to various embodiments.

Referring to FIG. 43, a display device 100 according to an embodiment of the present disclosure may be applied to smart glasses. The smart glasses may include a frame 111 and a lens part 112. The smart glasses are wearable electronic devices that can be worn on a user's face and may have a structure in which a portion of the frame 111 is folded or unfolded. For example, the smart glasses may be a wearable device for augmented reality (AR).

The frame 111 may include a housing 111b that supports a lens part 112 and a leg part 111a for wearing by the user. The leg part 111a is connected to the housing 111b by a hinge and may be folded or unfolded.

A battery, a touch pad, a microphone and/or a camera may be embedded into the frame 111. In addition, a projector that outputs light and/or a processor that controls light signals may be embedded into the frame 111.

The lens part 112 may be an optical member that transmits light or reflects light. The lens part 112 may include glass and/or transparent synthetic resin.

The display device 100 according to the embodiment of the present disclosure may be applied to the lens part 112. For example, the user may recognize an image displayed by an optical signal transmitted from the projector of the frame 111 through the lens part 112. For example, the user may recognize information such as time and date displayed on the lens part 112.

Referring to FIG. 44, a display device 100 according to an embodiment of the present disclosure may be applied to a head mounted display (HMD). The head mounted display may include a head mounted band 121 and a display storage case 122. For example, the head mounted display may be a wearable electronic device that can be worn on a user's head.

The head-mounted band 121 may be connected to the display storage case 122 and may fix the display storage case 122. The head-mounted band 121 includes a horizontal band and a vertical band to fix the head-mounted display to the user's head and the horizontal band may be provided to surround the side of the user's head and the vertical band may be provided to surround the upper part of the user's head. However, it is not necessarily limited thereto and the head-mounted band 121 may also be implemented in the form of a head-mounted band 121 eyeglass frame or a helmet.

The display storage case 122 stores the display device and may include at least one lens. The at least one lens may provide an image to the user. For example, the display device 100 according to the embodiment of the present disclosure may be applied to a left-eye lens and a right-eye lens implemented in the display storage case 122.

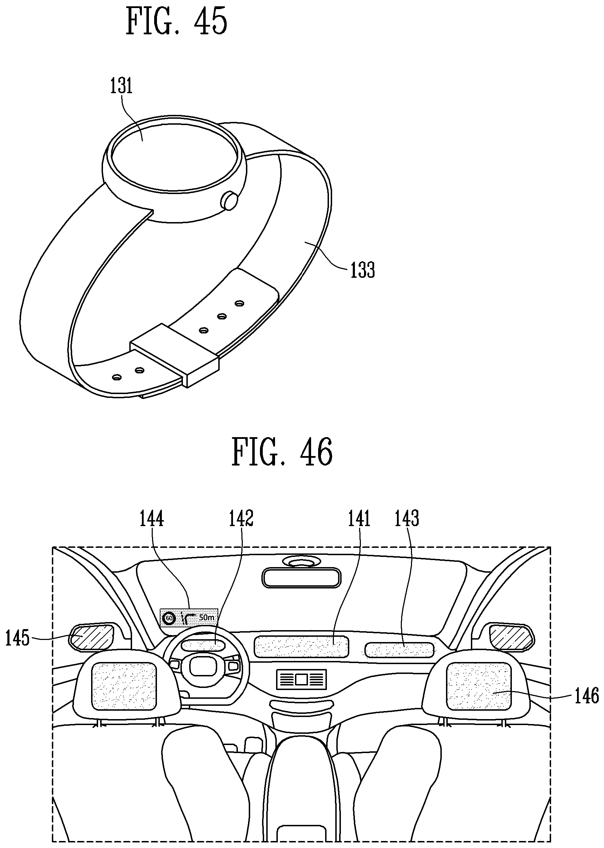

Referring to FIG. 45, the display device 100 according to an embodiment of the present disclosure may be applied to a smart watch. The smart watch may include a display 131 and a strap part 133. The smart watch is a wearable electronic device and the strap part 133 may be worn on the user's wrist. The display device 100 according to an embodiment of the present disclosure may be applied to the display 131. For example, the display 131 may provide image data including information such as time and date.

Referring to FIG. 46, a display device 100 according to an embodiment of the present disclosure may be applied to an automotive display. For example, the automotive display may refer to an electronic device that is installed inside and outside a vehicle and provides image data.

For example, the display device 100 according to the embodiment of the present disclosure may be applied to at least one of an infotainment panel 141, a cluster 142, a co-driver display 143, a head-up display 144, a side mirror display 145, and a rear seat display 146 provided in a vehicle.

Although the present disclosure has been described above with reference to embodiments thereof, it will be understood by those skilled in the art that various modifications and changes may be made to the present disclosure without departing from the scope of the present disclosure as set forth in the appended claims.

## Claims

1. A scan driver (130) for a display device (100), the scan driver (130) comprising:
a stage circuit (ST1) which controls a voltage of an output terminal (OUT) based on voltages of a first node (N1) and a second node (N2), where the stage circuit (ST1) comprises:
a first transistor (M1) connected between a first input terminal (IN1) and a third node (N3), a gate electrode of the first transistor (M1) being connected to a second input terminal (IN2);
a second transistor (M2) connected between a first power input terminal (VIN1) and the output terminal (OUT), a gate electrode of the second transistor (M2) being connected to the first node (N1);
a third transistor (M3) connected between a third input terminal (IN3) and the output terminal (OUT), a gate electrode of the third transistor (M3) being connected to the second node (N2);
a fourth transistor (M4) connected between the first node (N1) and the second input terminal (IN2), a gate electrode of the fourth transistor (M4) being connected to the third node (N3); and
a fifth transistor (M5) connected between the first node (N1) and a second power input terminal (VIN2), a gate electrode of the fifth transistor (M5) being connected to the second input terminal (IN2),
wherein the third node (N3) is electrically connected to the second node (N2) during at least a portion of a period in which the first transistor (M1) is turned on.

2. The scan driver (130) according to claim 1, further comprising:
a first capacitor (C1) connected between the output terminal (OUT) and the second node (N2); and
a second capacitor (C2) connected between the first power input terminal (VIN1) and the first node (N1).

3. The scan driver (130) according to claim 1 or 2, wherein the first input terminal (IN1) receives a start signal (FLM) or a carry signal from a previous stage circuit,
the second input terminal (IN2) receives a first clock signal (CLK1),
the third input terminal (IN3) receives a second clock signal (CLK2) having a same period but a different phase than the first clock signal (CLK1),
the first power input terminal (VIN1) receives a voltage of a first power source (VGH), and
the second power input terminal (VIN2) receives a voltage of a second power source (VGL) having a lower voltage than that of the first power source (VGH).

4. The scan driver (130) according to claims 1 to 3, further comprising a sixth transistor (M6) connected between the second node (N2) and the third node (N3), a gate electrode of the sixth transistor (M6) being connected to the second power input terminal (VIN2).

5. The scan driver (130) according to claims 1 to 4, further comprising a sixth transistor (M6) connected between the second node (N2) and the third node (N3), a gate electrode of the sixth transistor (M6) being connected to the second input terminal (IN2).

6. The scan driver (130) according to claims 1 to 5, further comprising a sixth transistor (M6) connected between the second node (N2) and the third node (N3), a gate electrode of the sixth transistor (M6) being connected to the first node (N1).

7. The scan driver (130) according to claims 1 to 6, further comprising an auxiliary transistor (MAa) connected in parallel to the first transistor (M1) across the first input terminal (IN1) and the third node (N3), a gate electrode of the auxiliary transistor (MAa) being connected to the first node (N1). and/or further comprising a sixth transistor (M6) connected between the second node (N2) and the third node (N3), a gate electrode of the sixth transistor (M6) being connected to the second power input terminal (VIN2) and/or to the second input terminal (IN2) and/or to the first node (N1).

8. The scan driver (130) according to claims 1 to 7, further comprising a seventh transistor (M7) connected between the first power input terminal (VIN1) and the third node (N3), a gate electrode of the seventh transistor (M7) being connected to the first node (N1) and/or further comprising a sixth transistor (M6) connected between the second node (N2) and the third node (N3), a gate electrode of the sixth transistor (M6) being connected to the second power input terminal (VIN2).

9. A display device (100) comprising:
pixels connected to scan lines (SL1-SLn) and data lines (DL1-DLm); and
a scan driver (130) comprising a plurality of stage circuits to supply scan signals to the scan lines (SL1-SLn),
wherein one of the plurality of stage circuits comprises:
a first transistor (M1) connected between a first input terminal (IN1) and a second node (N2), a gate electrode of the first transistor (M1) being connected to a second input terminal (IN2);
a second transistor (M2) connected between a first power input terminal (VIN1) and an output terminal (OUT), a gate electrode of the second transistor (M2) being connected to a first node (N1);
a third transistor (M3) connected between a third input terminal (IN3) and the output terminal (OUT), a gate electrode of the third transistor (M3) being connected to the second node (N2);
a fourth transistor (M4) connected between the first node (N1) and the second input terminal (IN2), a gate electrode of the fourth transistor (M4) being connected to the second node (N2); and
a fifth transistor (M5) connected between the first node (N1) and a second power input terminal (VIN2), a gate electrode of the fifth transistor (M5) being connected to the second input terminal (IN2).

10. The display device (100) according to claim 9, wherein one of the plurality of stage circuits further comprises:
a first capacitor (C1) connected between the output terminal (OUT) and the second node (N2); and
a second capacitor (C2) connected between the first power input terminal (VIN1) and the first node (N1).

11. The display device (100) according to claim 9 or 10, wherein the first input terminal (IN1) receives a start signal (FLM) or a carry signal from a previous stage circuit,
the second input terminal (IN2) receives a first clock signal (CLK1),
the third input terminal (IN3) receives a second clock signal (CLK2) having a same period but a different phase than the first clock signal (CLK1),
the first power input terminal (VIN1) receives a voltage of a first power source (VGH), and
the second power input terminal (VIN2) receives a voltage of a second power source (VGL) having a lower voltage than that of the first power source (VGH).

12. The display device (100) according to claims 9 to 11, wherein one of the plurality of stage circuits further comprising a sixth transistor (M6) connected between the second node (N2) and the third node (N3), a gate electrode of the sixth transistor (M6) being connected to the second power input terminal (VIN2).

13. An electronic device (1000), comprising
a processor (1110) to provide image data; and
a display (110, 131) device (100) to display (110, 131) an image based on the image data,
wherein the display (110, 131) device (100) comprises:
pixels connected to scan lines (SL1-SLn) and data lines (DL1-DLm); and
a scan driver (130) comprising a plurality of stage circuits to supply scan signals to the scan lines (SL1-SLn),
wherein one of the plurality of stage circuits comprises:
a first transistor (M1) connected between a first input terminal (IN1) and a second node (N2), a gate electrode of the first transistor (M1) being connected to a second input terminal (IN2);
a second transistor (M2) connected between a first power input terminal (VIN1) and an output terminal (OUT), a gate electrode of the second transistor (M2) being connected to a first node (N1);
a third transistor (M3) connected between a third input terminal (IN3) and the output terminal (OUT), a gate electrode of the third transistor (M3) being connected to the second node (N2);
a fourth transistor (M4) connected between the first node (N1) and the second input terminal (IN2), a gate electrode of the fourth transistor (M4) being connected to the second node (N2); and
a fifth transistor (M5) connected between the first node (N1) and a second power input terminal (VIN2), a gate electrode of the fifth transistor (M5) being connected to the second input terminal (IN2).

14. The electronic device (1000) according to claim 13, wherein one of the plurality of stage circuits further comprising a sixth transistor (M6) connected between the second node (N2) and the third node (N3), a gate electrode of the sixth transistor (M6) being connected to the second input terminal (IN2) and/or to the first node (N1).

15. The electronic device (1000) according to claim 13 or 14, wherein one of the plurality of stage circuits further comprising an auxiliary transistor (MAa) connected in parallel to the first transistor (M1) across the first input terminal (IN1) and the third node (N3), a gate electrode of the auxiliary transistor (MAa) being connected to the first node (N1).
